(19) Europäisches Patentamt
European Patent Office
Office européen des brevets

(11) EP 3 643 756 A1

(12) **EUROPEAN PATENT APPLICATION**
published in accordance with Art. 153(4) EPC

(43) Date of publication:
**29.04.2020 Bulletin 2020/18**

(21) Application number: **18820562.9**

(22) Date of filing: **18.06.2018**

(51) Int Cl.:
***C09D 11/36*** *(2014.01)* ***C08K 3/22*** *(2006.01)*
***C08K 3/36*** *(2006.01)* ***C08L 65/00*** *(2006.01)*
***C09D 11/52*** *(2014.01)* ***H01B 1/12*** *(2006.01)*
***H01L 51/50*** *(2006.01)* ***H01B 1/20*** *(2006.01)*

(86) International application number:
**PCT/JP2018/023165**

(87) International publication number:
**WO 2018/235783 (27.12.2018 Gazette 2018/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.06.2017 JP 2017120896**
**28.06.2017 JP 2017126611**

(71) Applicant: **Nissan Chemical Corporation**
**Tokyo 103-6119 (JP)**

(72) Inventors:
- **KANNO Yuta**
**Funabashi-shi**
**Chiba 274-0052 (JP)**
- **HIGASHI Masayuki**
**Funabashi-shi**
**Chiba 274-0052 (JP)**
- **MURAKAJI Haruka**
**Funabashi-shi**
**Chiba 274-0052 (JP)**
- **SHIBATA Chika**
**Funabashi-shi**
**Chiba 274-0052 (JP)**

(74) Representative: **Mewburn Ellis LLP**
**Aurora Building**
**Counterslip**
**Bristol BS1 6BX (GB)**

(54) **NONAQUEOUS INK COMPOSITION**

(57) The present invention relates to a non-aqueous ink composition containing (a) a polythiophene containing a repeating unit complying with formula (I); (b) metal oxide nanoparticles containing at least (b-1) a first metal oxide nanoparticle having an average primary particle diameter $d_1$ and (b-2) a second metal oxide nanoparticle having an average primary particle diameter $d_2$, wherein $d_1<d_2$; and (c) a liquid carrier containing one or more organic solvents, as well as a pile-up suppressor and a lifetime extension agent for an organic EL device, containing metal oxide nanoparticles containing at least the (b-1) and (b-2) described above, wherein $d_1<d_2$.



Printed by Jouve, 75001 PARIS (FR)

## Description

### TECHNICAL FIELD

The present invention relates to a non-aqueous ink composition comprising (a) a polythiophene, (b) metal oxide nanoparticles comprising at least a first metal oxide nanoparticle having an average primary particle diameter $d_1$ and a second metal oxide nanoparticle having an average primary particle diameter $d_2$ ($d_1$<$d_2$), and (c) a liquid carrier, as well as a pile-up suppressor and a lifetime extension agent for an organic EL device, comprising metal oxide nanoparticles comprising at least a first metal oxide nanoparticle having an average primary particle diameter $d_1$ and a second metal oxide nanoparticle having an average primary particle diameter $d_2$ ($d_1$ <$d_2$).

### BACKGROUND ART

Although useful advances are being made in energy saving devices such as, for example, organic-based organic light emitting diodes (OLEDs), polymer light emitting diodes (PLEDs), phosphorescent organic light emitting diodes (PHOLEDs), and organic photovoltaic devices (OPVs), further improvements are still needed in providing better materials processing and/or device performance for commercialization. For example, one promising type of material used in organic electronics is conducting polymers including, for example, polythiophenes. However, problems can arise with polymers' purity, processability, and instability in their neutral and/or conductive states. Also, it is important to have very good control over the solubility of polymers utilized in alternating layers of various devices' architectures (e.g., orthogonal or alternating solubility properties among adjacent layers in particular device architecture). These layers, for example, also known as hole injection layers (HILs) and hole transport layers (HTLs), can present difficult problems in view of competing demands and the need for very thin, but high quality, films.

In a typical OLED device stack, the refractive index for most p-doped polymeric HILs is around 1.5, such as HILs comprising PEDOT:PSS, while the emissive materials generally have a refractive index that is substantially higher (1.7 or higher). As a result, additional total internal reflection occurs at the EML/HIL (or HTL/HIL) and HIL/ITO interfaces, leading to reduced light extraction efficiency.

There is an ongoing unresolved need for a good platform system to control properties of hole injection and transport layers, such as solubility, thermal/chemical stability, and electronic energy levels, such as HOMO and LUMO, so that the compounds can be adapted for different applications and to function with different compounds, such as light emitting layers, photoactive layers, and electrodes. Good solubility, intractability, and thermal stability properties are important. Also of importance is the ability to tune HIL resistivity and HIL layer thickness while retaining high transparency, low absorptivity, low internal reflection, low operating voltage, within the OLED system, and prolonged lifetime, among other properties. The ability to formulate the system for a particular application and provide the required balance of such properties is also important.

One known method for forming an HIL and a charge transporting film of an organic EL device such as an HIL is applying an ink composition consisting mainly of a liquid carrier in which a conductive polymer is dispersed or dissolved on a substrate (more precisely, on a thin film electrode formed on the substrate in many cases) to form a coating film, and drying the obtained coating film to remove the liquid carrier, thereby forming a charge transporting film. Since an organic EL device is deteriorated by contact with moisture, it is preferable that the ink composition be non-aqueous. In addition, non-aqueous ink compositions having various compositions have been proposed for the purpose of, among others, improving various characteristics of charge transporting films and organic EL devices comprising the same.

Patent Document 1 discloses a non-aqueous ink composition comprising an amine compound. Not only does the presence of an amine compound in the non-aqueous ink composition result in a non-aqueous ink composition having good shelf life and stability, thin films formed from the non-aqueous ink composition exhibit excellent homogeneity, and OLED devices comprising HILs formed from the non-aqueous ink composition exhibit good performance.

Patent Documents 2 and 3 disclose non-aqueous ink compositions comprising metal and/or semimetal nanoparticles. These nanoparticles are useful, for example, for improving characteristics such as luminance, thermal stability, hole injectability, and the like in an organic EL device, and for reducing variation in characteristics among finished products.

Various methods for applying such non-aqueous ink compositions are known. One example of such a method is an ink jetting method (droplet discharge method) in which a non-aqueous ink composition is discharged as minute droplets from a nozzle and adhered to an object to be coated. When, in order to manufacture an organic EL device, a charge transporting film is formed on a substrate using an ink jetting method, a method is often employed in which a bank (partition wall) is formed on a thin film electrode (a patterned thin film electrode in many cases) formed on the substrate so that the desired region on the thin film electrode is partitioned off by the bank as a film formation region, and a non-aqueous ink composition is applied only to the film formation region by an ink jetting method to form a charge transporting film.

A charge transporting film formed as described above preferably has a thickness uniform over the entire film.

In reality, however, particularly when the charge transporting film is formed by a method that uses a bank as described above, the resulting charge transporting film may have non-uniform thickness. One such example is a situation in which the thickness at the periphery of the formed charge transporting film increases along the direction from the center toward the edge of the film. This arises from the increase in thickness at the periphery of the formed coating film along the direction from the center of the coating film toward the edge (i.e. the area where the coating film comes in contact with the side of the bank) caused by the climbing of the side of the bank by the non-aqueous ink composition applied in the film formation region. A charge transporting film formed from a coating film in this state will have non-uniform thickness as described above. Herein, this phenomenon, in which the non-aqueous ink composition climbs the side of the bank, is referred to as the "pile-up phenomenon" or simply "pile-up."

The side of the bank that comes in contact with the non-aqueous ink composition (coating film) is often subjected to treatment (e.g., a predetermined plasma treatment) for imparting repellency to the non-aqueous ink composition so that the applied non-aqueous ink composition can form a coating film having a uniform thickness in the film formation region without adhering to the side of the bank; and the surface of the substrate (thin film electrode) serving as the film formation region is often subjected to treatment (e.g., another predetermined type of plasma treatment) for imparting affinity to the non-aqueous ink composition. Herein, a substrate that has been subjected to such treatment is referred to as a "substrate having a liquid repellent bank." However, even if a substrate having a liquid repellent bank is used, the pile-up phenomenon may not be sufficiently suppressed in some cases.

As described above, various additional components are often added to the non-aqueous ink composition for such purposes as improving various characteristics of the charge transporting film and an organic EL device comprising the same. Depending on the added components, however, this may induce the pile-up phenomenon. Indeed, as described below, the inventors have found that under certain conditions, the addition of metal oxide nanoparticles to a non-aqueous ink composition results in a significant manifestation of the pile-up phenomenon.

The non-uniformity of the thickness of the charge transporting film caused by the pile-up phenomenon may cause electrical defects (generation of leakage current, short-circuit, etc.) through regions where the thickness of the film is increased, which leads to a shortened lifetime of the organic EL device. In addition, the non-uniformity of the thickness of the charge transporting film causes thickness non-uniformity in the light emitting layer adjacent thereto, and this, together with the electrical defects, may cause an uneven emission of light in the organic EL device.

As a means for suppressing the pile-up phenomenon, for example, it has been proposed to appropriately adjust the composition of the liquid carrier in an ink composition (see Patent Documents 4 and 5). However, the ink composition in this case is composed only of a liquid carrier and a conductive material, and is not intended to suppress the pile-up phenomenon in an ink composition comprising additional components as described above.

That is, no means for suppressing a pile-up phenomenon in a non-aqueous ink composition comprising an additional component for such purposes as improving characteristics of the charge transporting film or the organic EL device are as yet known.

## PRIOR ART DOCUMENTS

### Patent Documents

Patent Document 1: WO 2016/171935
Patent Document 2: WO 2017/014945
Patent Document 3: WO 2017/014946
Patent Document 4: WO 2016/140205
Patent Document 5: JP-A-2015-185640


## SUMMARY

### Problems to be Solved by the Invention

Under these circumstances, the present inventors have carried out intensive research to develop a means for suppressing the pile-up phenomenon in a non-aqueous ink composition comprising an additional component as described above. As a result, the present inventors have surprisingly found that in a non-aqueous ink composition prepared by adding metal oxide nanoparticles to a combination of a specific polythiophene (conductive polymer) and a liquid carrier, there is a correlation between the state of dispersion of the metal oxide nanoparticles in the composition and the occurrence of the pile-up phenomenon, and that the more uniform the dispersion, the more pronounced the occurrence of the pile-up phenomenon.

The present inventors have also found that a moderate widening of the particle size distribution of the metal oxide nanoparticles allows the state of dispersion to be controlled appropriately, thereby suppressing the pile-up phenomenon, because it is believed that the state of dispersion of the metal oxide nanoparticles in the non-aqueous ink composition reflects the particle size distribution of the metal oxide nanoparticles, and that the narrower the particle size distribution, the more uniform the state of dispersion of the metal oxide nanoparticles.

The present inventors have also found that use of metal oxide nanoparticles comprising at least two kinds of metal oxide nanoparticles having mutually different primary particle diameters for the metal oxide nanoparticles having a moderately wide particle size distribution as described above allows the pile-up phenomenon to be greatly suppressed and a charge transporting film having a uniform thickness to be obtained easily.

The present inventors have further found that the suppression of the pile-up phenomenon tended to have the opposite effect of deteriorating certain characteristics, such as current efficiency, of the obtained organic EL device when such metal oxide nanoparticles as described above were not used, whereas, surprisingly, it did not excessively deteriorate organic EL device characteristics, when the metal oxide nanoparticles described above were used.

On the basis of the new findings above, the present invention has been completed.

Accordingly, a main object of the present invention is to provide a non-aqueous ink composition that provides a charge transporting film having uniform thickness without excessively deteriorating organic EL device characteristics.

Another object of the present invention is to provide a pile-up suppressor for a non-aqueous ink composition and a lifetime extension agent for an organic EL device that do not excessively deteriorate organic EL device characteristics.

The above and other objects, features and advantages of the present invention will become apparent from the following detailed description and claims taken in conjunction with the accompanying drawings.

That is, the present invention provides the following inventions.

1. A non-aqueous ink composition comprising:

(a) a polythiophene comprising a repeating unit complying with formula (I):

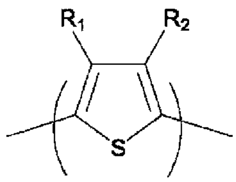

(I)

wherein $R_1$ and $R_2$ are each, independently, H, alkyl, fluoroalkyl, alkoxy, aryloxy, or $-O-[Z-O]_p-R_e$;
wherein

Z is an optionally halogenated hydrocarbylene group,
p is equal to or greater than 1, and
$R_e$ is H, alkyl, fluoroalkyl, or aryl;

(b) metal oxide nanoparticles comprising at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1<d_2$; and

(c) a liquid carrier comprising one or more organic solvents.

2. The composition according to preceding item 1, wherein the average primary particle diameter $d_1$ is less than 15 nm, and the average primary particle diameter $d_2$ is equal to or greater than 10 nm.
3. The composition according to preceding item 1 or 2, wherein the average primary particle diameter $d_1$ is equal to or greater than 3 nm and less than 15 nm; and the average primary particle diameter $d_2$ is equal to or greater than 10 nm and equal to or less than 30 nm.
4. The non-aqueous ink composition according to any one of preceding items 1 to 3, wherein the average primary particle diameters $d_1$ and $d_2$ satisfy the relation $d_2/d_1 > 1.5$.
5. The non-aqueous ink composition according to any one of preceding items 1 to 4, wherein the average primary

particle diameters $d_1$ and $d_2$ satisfy the relation $d_2/d_1 > 2.0$.

6. The non-aqueous ink composition according to any one of preceding items 1 to 5, wherein the amount of the metal oxide nanoparticles (b) is 1% by weight to 98% by weight relative to the combined weight of the metal oxide nanoparticles (b) and the polythiophene (a).

7. The non-aqueous ink composition according to any one of preceding items 1 to 6, wherein the weight ratio (b-1)/(b-2) of the first metal oxide nanoparticle (b-1) to the second metal oxide nanoparticle (b-2) in the metal oxide nanoparticles (b) is in the range of 0.001 to 1,000.

8. The non-aqueous ink composition according to any one of preceding items 1 to 7, wherein the first metal oxide nanoparticle (b-1) and the second metal oxide nanoparticle (b-2) each comprise, independently, $B_2O_3$, $B_2O$, $SiO_2$, $SiO$, $GeO_2$, $GeO$, $As_2O_4$, $As_2O_3$, $As_2O_5$, $Sb_2O_3$, $TeO_2$, $SnO_2$, $SnO$, or mixtures thereof.

9. The non-aqueous ink composition according to preceding item 8, wherein the first metal oxide nanoparticle (b-1) and the second metal oxide nanoparticle (b-2) both comprise $SiO_2$.

10. The non-aqueous ink composition according to any one of preceding items 1 to 9, wherein the liquid carrier is a liquid carrier comprising at least one glycol-based solvent (A) and at least one organic solvent (B) other than a glycol-based solvent.

11. The non-aqueous ink composition according to preceding item 10, wherein the glycol-based solvent (A) is a glycol ether, a glycol monoether, or a glycol.

12. The non-aqueous ink composition according to preceding item 10 or 11, wherein the organic solvent (B) is a nitrile, an alcohol, an aromatic ether, or an aromatic hydrocarbon.

13. The non-aqueous ink composition according to any one of preceding items 1 to 12, wherein $R_1$ and $R_2$ are each, independently, H, fluoroalkyl, $-O[C(R_aR_b)-C(R_cR_d)-O]_p-R_e$, $-OR_f$; wherein each occurrence of $R_a$, $R_b$, $R_c$, and $R_d$ is each, independently, H, halogen, alkyl, fluoroalkyl, or aryl; $R_e$ is H, alkyl, fluoroalkyl, or aryl; p is 1, 2, or 3; and $R_f$ is alkyl, fluoroalkyl, or aryl.

14. The non-aqueous ink composition according to preceding item 13, wherein $R_1$ is H and $R_2$ is other than H.

15. The non-aqueous ink composition according to preceding item 13, wherein $R_1$ and $R_2$ are both other than H.

16. The non-aqueous ink composition according to preceding item 15, wherein $R_1$ and $R_2$ are each, independently, $-O[C(R_aR_b)-C(R_cR_d)-O]_p-R_e$, or $-OR_f$.

17. The non-aqueous ink composition according to preceding item 15, wherein $R_1$ and $R_2$ are both $-O[C(R_aR_b)-C(R_cR_d)-O]_p-R_e$.

18. The non-aqueous ink composition according to preceding item 16 or 17, wherein each occurrence of $R_a$, $R_b$, $R_c$, and $R_d$ is each, independently, H, $(C_1-C_8)$ alkyl, $(C_1-C_8)$ fluoroalkyl, or phenyl; and $R_e$ is $(C_1-C_8)$ alkyl, $(C_1-C_8)$ fluoroalkyl, or phenyl.

19. The non-aqueous ink composition according to any one of preceding items 1 to 12, wherein the polythiophene comprises a repeating unit selected from the group consisting of

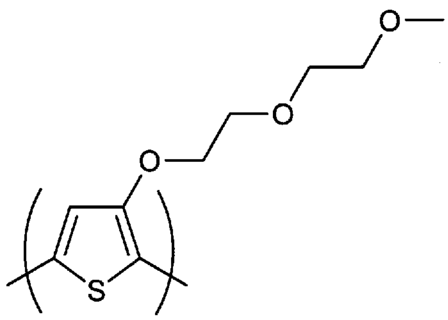

,

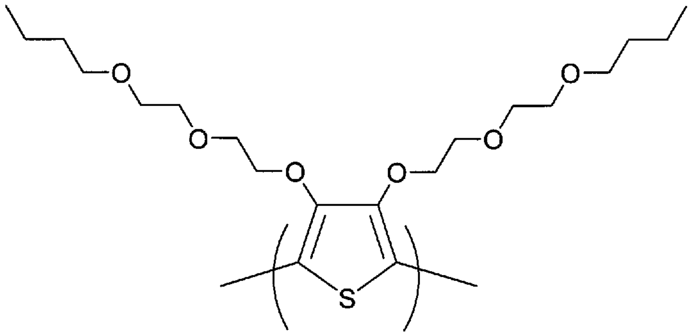

,

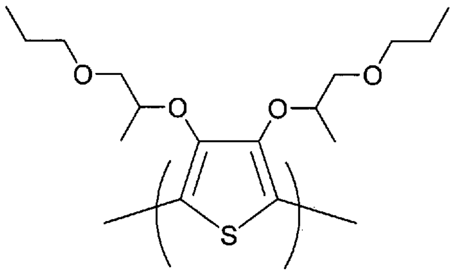

,

and combinations thereof.

20. The non-aqueous ink composition according to any one of preceding items 1 to 12, wherein the polythiophene is sulfonated.

21. The non-aqueous ink composition according to preceding item 20, wherein the polythiophene is sulfonated poly(3-MEET).

22. The non-aqueous ink composition according to any one of preceding items 1 to 21, wherein the polythiophene comprises repeating units complying with formula (I) in an amount of greater than 50% by weight, typically greater than 80% by weight, more typically greater than 90% by weight, even more typically greater than 95% by weight, based on the total weight of the repeating units.

23. The non-aqueous ink composition according to any one of preceding items 1 to 22, further comprising a synthetic polymer comprising one or more acidic groups.

24. The non-aqueous ink composition according to preceding item 23, wherein the synthetic polymer is a polymeric acid comprising one or more repeating units comprising at least one alkyl or alkoxy group substituted by at least one fluorine atom and at least one sulfonic acid ($-SO_3H$) moiety, wherein said alkyl or alkoxy group is optionally interrupted by at least one ether linking (-O-) group.

25. The non-aqueous ink composition according to preceding item 24, wherein the polymeric acid comprises a repeating unit complying with formula (II) and a repeating unit complying with formula (III):

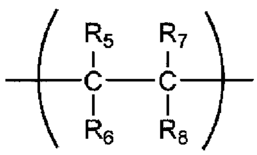

(II)

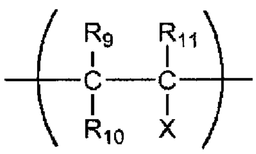

(III)

wherein

each occurrence of $R_5$, $R_6$, $R_7$, $R_8$, $R_9$, $R_{10}$, and $R_{11}$ is, independently, H, halogen, fluoroalkyl, or perfluoroalkyl;

and
X is $-[OC(R_hR_i)-C(R_jR_k)]_q-O-[CR_lR_m]_z-SO_3H$,
wherein

each occurrence of $R_h$, $R_i$, $R_j$, $R_k$, $R_l$ and $R_m$ is, independently, H, halogen, fluoroalkyl, or perfluoroalkyl;
q is 0 to 10; and
z is 1 to 5.

26. The non-aqueous ink composition according to preceding item 23, wherein the synthetic polymer is a polyether sulfone comprising one or more repeating units comprising at least one sulfonic acid ($-SO_3H$) moiety.
27. The non-aqueous ink composition according to any one of preceding items 1 to 26, further comprising at least one amine compound.
28. The non-aqueous ink composition according to preceding item 27, wherein the amine compound comprises a tertiary alkylamine compound and an amine compound other than a tertiary alkylamine compound.
29. The non-aqueous ink composition according to preceding item 28, wherein the amine compound other than a tertiary alkylamine compound is a primary alkylamine compound.
30. The non-aqueous ink composition according to preceding item 29, wherein the primary alkylamine compound is at least one selected from the group consisting of ethylamine, n-butylamine, t-butylamine, n-hexylamine, 2-ethylhexylamine, n-decylamine, and ethylenediamine.
31. The non-aqueous ink composition according to preceding item 30, wherein the primary alkylamine compound is 2-ethylhexylamine or n-butylamine.
32. A pile-up suppressor for suppressing a pile-up phenomenon occurring during the formation of a charge transporting film by applying to a substrate having a liquid repellent bank, and drying, a non-aqueous ink composition if added to the non-aqueous ink composition, the pile-up suppressor comprising metal oxide nanoparticles, wherein the metal oxide nanoparticles comprise at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1<d_2$.

33. The pile-up suppressor according to preceding item 32, wherein the average primary particle diameters $d_1$ and $d_2$ satisfy the relation $d_2/d_1 > 1.5$.
34. The pile-up suppressor according to preceding item 32 or 33, wherein the average primary particle diameters $d_1$ and $d_2$ satisfy the relation $d_2/d_1 > 2.0$.
35. The pile-up suppressor according to any one of preceding items 32 to 34, wherein the first metal oxide nanoparticle (b-1) and the second metal oxide nanoparticle (b-2) each comprise, independently, $B_2O_3$, $B_2O$, $SiO_2$, SiO, $GeO_2$, GeO, $As_2O_4$, $As_2O_3$, $As_2O_5$, $Sb_2O_3$, $TeO_2$, $SnO_2$, SnO, or mixtures thereof.
36. The pile-up suppressor according to preceding item 35, wherein the first metal oxide nanoparticle (b-1) and the second metal oxide nanoparticle (b-2) both comprise $SiO_2$.
37. A non-aqueous ink composition comprising:

(a) a polythiophene comprising a repeating unit complying with formula (I):

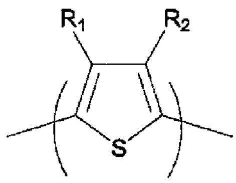

(I)

wherein $R_1$ and $R_2$ are each, independently, H, alkyl, fluoroalkyl, alkoxy, aryloxy, or $-O-[Z-O]_p-R_e$;
wherein

Z is an optionally halogenated hydrocarbylene group,
p is equal to or greater than 1, and
$R_e$ is H, alkyl, fluoroalkyl, or aryl;

(b) metal oxide nanoparticles comprising at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1 < d_2$;

(c) a liquid carrier comprising one or more organic solvents;
(d) a synthetic polymer comprising one or more acidic groups; and
(e) at least one amine compound.

38. A lifetime extension agent for an organic EL device, comprising metal oxide nanoparticles, wherein the metal oxide nanoparticles comprise at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1 < d_2$.

39. The lifetime extension agent according to preceding item 38, wherein the average primary particle diameters $d_1$ and $d_2$ satisfy the relation $d_2/d_1 > 1.5$.
40. The lifetime extension agent according to preceding item 38 or 39, wherein the average primary particle diameters $d_1$ and $d_2$ satisfy the relation $d_2/d_1 > 2.0$.

**Effect of the Invention**

The non-aqueous ink composition of the present invention suppresses the pile-up phenomenon occurring when a charge transporting film is formed by applying to a substrate having a liquid repellent bank, and drying, the non-aqueous ink composition, thereby allowing a charge transporting film having a uniform thickness to be easily obtained. Further, the non-aqueous ink composition of the present invention does not excessively deteriorate organic EL device characteristics.

**Brief Description of the Drawings**

FIG. 1 is a graph comparing the cross-sectional shapes of the charge transporting films obtained in Example 1 and Comparative Example 1.
FIG. 2 is a graph comparing the cross-sectional shapes of the charge transporting films obtained in Examples 2 to 5 and Comparative Examples 2 to 3.

**Description of Embodiments**

As used herein, the terms "a", "an", or "the" means "one or more" or "at least one" unless otherwise stated.
As used herein, the term "comprises" includes "consists essentially of' and "consists of." The term "comprising" includes "consisting essentially of' and "consisting of."
The phrase "free of' means that there is no external addition of the material modified by the phrase and that there is no detectable amount of the material that may be observed by analytical techniques known to the ordinarily-skilled artisan, such as, for example, gas or liquid chromatography, spectrophotometry, optical microscopy, and the like.
Throughout the present invention, various publications are incorporated by reference. Should the meaning of any language in such publications incorporated by reference conflict with the meaning of the language of the present invention, the meaning of the language of the present invention shall take precedence, unless otherwise indicated.
As used herein, the terminology "($C_x$-$C_y$)" in reference to an organic group, wherein x and y are each integers, means that the group may contain from x carbon atoms to y carbon atoms per group.
As used herein, the term "alkyl" means a monovalent straight or branched saturated hydrocarbon radical, more typically, a monovalent straight or branched saturated ($C_1$-$C_{40}$) hydrocarbon radical, such as, for example, methyl, ethyl, n-propyl, isopropyl, n-butyl, isobutyl, tert-butyl, hexyl, 2-ethylhexyl, octyl, hexadecyl, octadecyl, eicosyl, behenyl, tricontyl, and tetracontyl.
As used herein, the term "fluoroalkyl" means an alkyl radical as defined herein, more typically a ($C_1$-$C_{40}$) alkyl radical that is substituted with one or more fluorine atoms. Examples of fluoroalkyl groups include, for example, difluoromethyl, trifluoromethyl, perfluoroalkyl, 1H,1H,2H,2H-perfluorooctyl, perfluoroethyl, and-$CH_2CF_3$.

As used herein, the term "hydrocarbylene" means a divalent radical formed by removing two hydrogen atoms from a hydrocarbon, typically a ($C_1$-$C_{40}$) hydrocarbon. Hydrocarbylene groups may be straight, branched or cyclic, and may be saturated or unsaturated. Examples of hydrocarbylene groups include, but are not limited to, methylene, ethylene, 1-methylethylene, 1-phenylethylene, propylene, butylene, 1,2-benzene; 1,3-benzene; 1,4-benzene; and 2,6-naphthalene.

As used herein, the term "alkoxy" means a monovalent radical denoted as-O-alkyl, wherein the alkyl group is as defined herein. Examples of alkoxy groups, include, but are not limited to, methoxy, ethoxy, n-propoxy, isopropoxy, n-butoxy, isobutoxy, and tert-butoxy.

As used herein, the term "aryl" means a monovalent unsaturated hydrocarbon radical containing one or more six-membered carbon rings in which the unsaturation may be represented by three conjugated double bonds. Aryl radicals include monocyclic aryl and polycyclic aryl. Polycyclic aryl refers to a monovalent unsaturated hydrocarbon radical containing more than one six-membered carbon ring in which the unsaturation may be represented by three conjugated double bonds wherein adjacent rings may be linked to each other by one or more bonds or divalent bridging groups or may be fused together. Examples of aryl radicals include, but are not limited to, phenyl, anthracenyl, naphthyl, phenanthrenyl, fluorenyl, and pyrenyl.

As used herein, the term "aryloxy" means a monovalent radical denoted as-O-aryl, wherein the aryl group is as defined herein. Examples of aryloxy groups, include, but are not limited to, phenoxy, anthracenoxy, naphthoxy, phenanthrenoxy, and fluorenoxy.

Any substituent or radical described herein may optionally be substituted at one or more carbon atoms with one or more, same or different, substituents described herein. For instance, a hydrocarbylene group may be further substituted with an aryl group or an alkyl group. Any substituent or radical described herein may also optionally be substituted at one or more carbon atoms with one or more substituents selected from the group consisting of halogen, such as, for example, F, Cl, Br, and I; nitro ($NO_2$), cyano (CN), and hydroxy (OH).

As used herein, the term "hole carrier compound" refers to any compound that is capable of facilitating the movement of holes, i.e., positive charge carriers, and/or blocking the movement of electrons, for example, in an electronic device. Hole carrier compounds include compounds useful in layers (HTLs), hole injection layers (HILs) and electron blocking layers (EBLs) of electronic devices, typically organic electronic devices, such as, for example, organic light emitting devices.

As used herein, the term "doped" in reference to a hole carrier compound, for example, a polythiophene, means that the hole carrier compound has undergone a chemical transformation, typically an oxidation or reduction reaction, more typically an oxidation reaction, facilitated by a dopant. As used herein, the term "dopant" refers to a substance that oxidizes or reduces, typically oxidizes, a hole carrier compound, for example, a polythiophene. Herein, the process wherein a hole carrier compound undergoes a chemical transformation, typically an oxidation or reduction reaction, more typically an oxidation reaction, facilitated by a dopant is called a "doping reaction" or simply "doping". Doping alters the properties of the polythiophene, which properties may include, but may not be limited to, electrical properties, such as resistivity and work function, mechanical properties, and optical properties. In the course of a doping reaction, the hole carrier compound becomes charged, and the dopant, as a result of the doping reaction, becomes the oppositely-charged counterion for the doped hole carrier compound. As used herein, a substance must chemically react, oxidize or reduce, typically oxidize, a hole carrier compound to be referred to as a dopant. Substances that do not react with the hole carrier compound but may act as counterions are not considered dopants according to the present invention. Accordingly, the term "undoped" in reference to a hole carrier compound, for example a polythiophene, means that the hole carrier compound has not undergone a doping reaction as described herein.

The present invention relates to a non-aqueous ink composition comprising:

(a) a polythiophene comprising a repeating unit complying with formula (I):

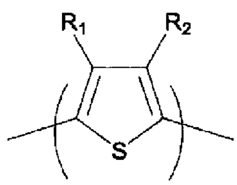

(I)

wherein $R_1$ and $R_2$ are each, independently, H, alkyl, fluoroalkyl, alkoxy, aryloxy, or -O-[Z-O]$_p$-$R_e$;
wherein

Z is an optionally halogenated hydrocarbylene group,
p is equal to or greater than 1, and
$R_e$ is H, alkyl, fluoroalkyl, or aryl;

(b) metal oxide nanoparticles comprising at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1<d_2$; and

(c) a liquid carrier comprising one or more organic solvents.

The ink composition of the present invention is non-aqueous. As used herein, "non-aqueous" means that the total amount of water in the non-aqueous ink composition of the present invention is from 0 to 2 wt. %, with respect to the total amount of the non-aqueous ink composition. Typically, the total amount of water in the non-aqueous ink composition is from 0 to 1 wt. %, more typically from 0 to 0.5 wt. %, with respect to the total amount of the non-aqueous ink composition. In an embodiment, the non-aqueous ink composition of the present invention is substantially free of water.
A polythiophene suitable for use in the present disclosure comprises a repeating unit complying with formula (I):

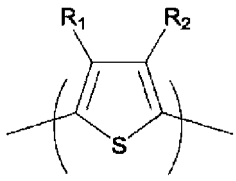

(I)

wherein $R_1$ and $R_2$ are each, independently, H, alkyl, fluoroalkyl, alkoxy, aryloxy, or $-O-[Z-O]_p-R_e$;
wherein

Z is an optionally halogenated hydrocarbylene group,
p is equal to or greater than 1, and
$R_e$ is H, alkyl, fluoroalkyl, or aryl.

In an embodiment, $R_1$ and $R_2$ are each, independently, H, fluoroalkyl,$-O[C(R_aR_b)-C(R_cR_d)-O]_p-R_e$, or $-OR_f$; wherein each occurrence of $R_a$, $R_b$, $R_c$, and $R_d$ is each, independently, H, halogen, alkyl, fluoroalkyl, or aryl; $R_e$ is H, alkyl, fluoroalkyl, or aryl; p is 1, 2, or 3; and $R_f$ is alkyl, fluoroalkyl, or aryl.
In an embodiment, $R_1$ is H and $R_2$ is other than H. In such an embodiment, the repeating unit is derived from a 3-substituted thiophene.
The polythiophene can be a regiorandom or a regioregular compound. Due to its asymmetrical structure, the polymerization of 3-substituted thiophenes produces a mixture of polythiophene structures containing three possible regiochemical linkages between repeat units. The three orientations available when two thiophene rings are joined are the 2,2'; 2,5', and 5,5' couplings. The 2,2' (or head-to-head) coupling and the 5,5' (or tail-to-tail) coupling are referred to as regiorandom couplings. In contrast, the 2,5' (or head-to-tail) coupling is referred to as a regioregular coupling. The degree of regioregularity can be, for example, about 0 to 100%, or about 25 to 99.9%, or about 50 to 98%. Regioregularity may be determined by standard methods known to those of ordinary skill in the art, such as, for example, using NMR spectroscopy.
In an embodiment, the polythiophene is regioregular. In some embodiments, the regioregularity of the polythiophene can be at least about 85%, typically at least about 95%, more typically at least about 98%. In some embodiments, the degree of regioregularity can be at least about 70%, typically at least about 80%. In yet other embodiments, the regioregular polythiophene has a degree of regioregularity of at least about 90%, typically a degree of regioregularity of at least about 98%.
3-Substituted thiophene monomers, including polymers derived from such monomers, are commercially available or may be made by methods known to those of ordinary skill in the art. Synthetic methods, doping, and polymer characterization, including regioregular polythiophenes with side groups, are provided in, for example, U.S. Patent No. 6,602,974 to McCullough et al. and U.S. Patent No. 6,166,172 to McCullough et al.
In another embodiment, $R_1$ and $R_2$ are both other than H. In such an embodiment, the repeating unit is derived from a 3,4-disubstituted thiophene.
In an embodiment, $R_1$ and $R_2$ are each, independently, $-O[C(R_aR_b)-C(R_eR_d)-O]_p-R_e$, or $-OR_f$. In an embodiment,

$R_1$ and $R_2$ are both $-O[C(R_aR_b)-C(R_cRd)-O]_p-R_e$. $R_1$ and $R_2$ may be the same or different.

In an embodiment, each occurrence of $R_a$, $R_b$, $R_c$, and $R_d$ is each, independently, H, $(C_1-C_8)$ alkyl, $(C_1-C_8)$ fluoroalkyl, or phenyl; and $R_e$ is $(C_1-C_8)$ alkyl, $(C_1-C_8)$ fluoroalkyl, or phenyl.

In an embodiment, $R_1$ and $R_2$ are each $-O[CH_2-CH_2-O]_p-R_e$. In an embodiment, $R_1$ and $R_2$ are each $-O[CH(CH_3)-CH_2-O]_p-R_e$.

In an embodiment, $R_e$ is methyl, propyl, or butyl.

In an embodiment, the polythiophene comprises a repeating unit selected from the group consisting of

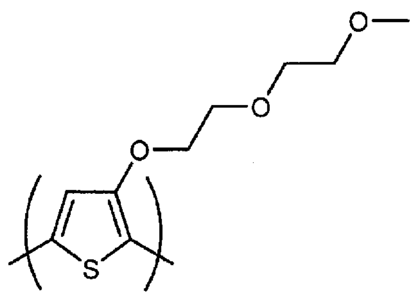

,

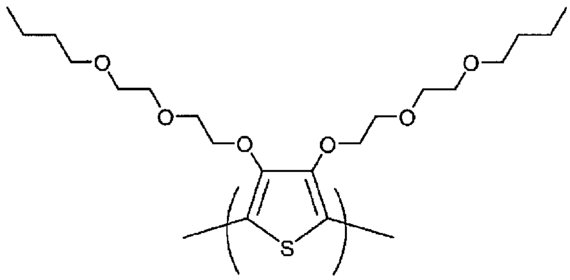

,

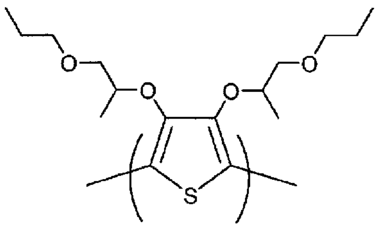

,

and combinations thereof.

It would be clear to the ordinarily-skilled artisan that the repeating unit

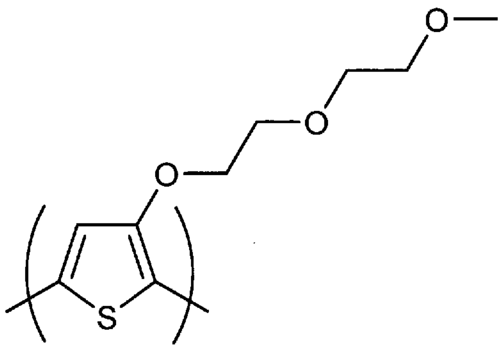

is derived from a monomer represented by the following structure:

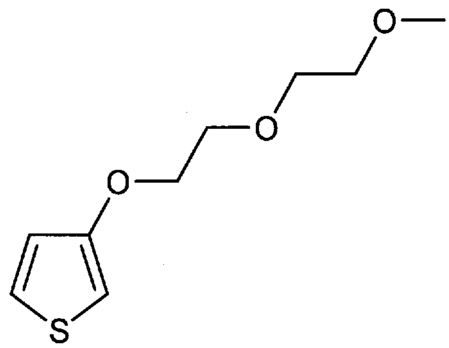

3-(2-(2-methoxyethoxy)ethoxy)thiophene
[referred to herein as 3-MEET];

The repeating unit

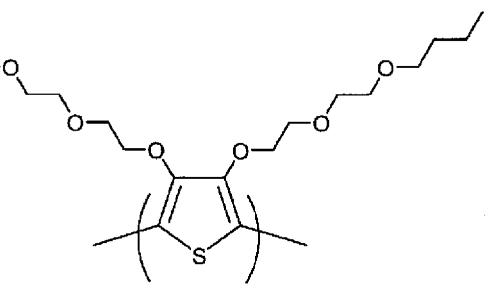

is derived from a monomer represented by the following structure:

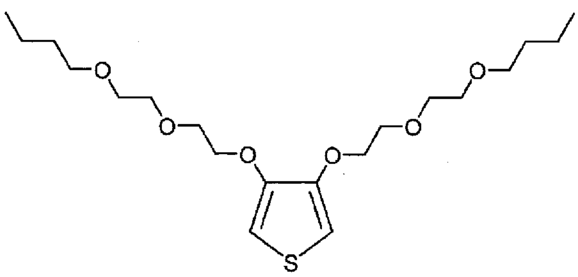

,

3,4-bis(2-(2-butoxyethoxy)ethoxy)thiophene
[referred to herein as 3,4-diBEET]; and

The repeating unit

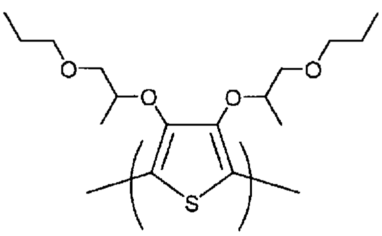

,

is derived from a monomer represented by the following structure:

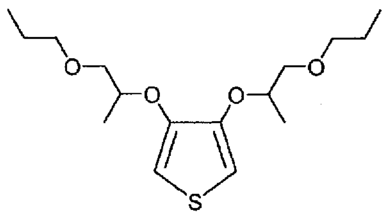

,

3,4-bis((1-propoxypropan-2-yl)oxy)thiophene
[referred to herein as 3,4-diPPT];

3,4-Disubstituted thiophene monomers, including polymers derived from such monomers, are commercially available or may be made by methods known to those of ordinary skill in the art. For example, a 3,4-disubstituted thiophene monomer may be produced by reacting 3,4-dibromothiophene with a metal salt, typically the sodium salt, of a compound given by the formula HO-$[Z\text{-}O]_p$-$R_e$ or $HOR_f$, wherein Z, $R_e$, $R_f$ and p are as defined herein.

The polymerization of 3,4-disubstituted thiophene monomers may be carried out by, first, brominating the 2 and 5 positions of the 3,4-disubstituted thiophene monomer to form the corresponding 2,5-dibromo derivative of the 3,4-disubstituted thiophene monomer. The polymer can then be obtained by GRIM (Grignard methathesis) polymerization of the 2,5-dibromo derivative of the 3,4-disubstituted thiophene in the presence of a nickel catalyst. Such a method is described, for example, in US Patent 8,865,025, the entirety of which is hereby incorporated by reference. Another known method of polymerizing thiophene monomers is by oxidative polymerization using organic non-metal containing oxidants, such as 2,3-dichloro-5,6-dicyano-1,4-benzoquinone (DDQ), or using a transition metal halide, such as, for example, iron(III) chloride, molybdenum(V) chloride, and ruthenium(III) chloride, as an oxidizing agent.

Examples of compounds having the formula HO-$[Z\text{-}O]_p$-$R_e$ or $HOR_f$ that may be converted to a metal salt, typically a sodium salt, and used to produce 3,4-disubstituted thiophene monomers include, but are not limited to, trifluoroethanol, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), diethylene glycol monophenyl ether (phenyl Carbitol), ethylene glycol monobutyl ether (butyl Cellosolve), diethylene glycol monobutyl ether (butyl Carbitol), dipropylene glycol monomethyl ether (Dowanol DPM), diisobutyl carbinol, 2-ethylhexyl alcohol, methyl isobutyl carbinol, ethylene glycol monophenyl ether (Dowanol Eph), propylene glycol monopropyl ether (Dowanol PnP), propylene glycol monophenyl ether (Dowanol PPh), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

The polythiophene having a repeating unit complying with formula (I) of the present disclosure may be further modified subsequent to its formation by polymerization. For instance, polythiophenes having one or more repeating units derived from 3-substituted thiophene monomers may possess one or more sites where a hydrogen may be replaced by a substituent, such as a sulfonic acid group ($-SO_3H$) by sulfonation.

As used herein, the term "sulfonated" in relation to a polythiophene means that the polythiophene comprises one or more sulfonic acid groups ($-SO_3H$). Typically, the sulfur atom of the $-SO_3H$ group is directly bonded to the backbone of the polythiophene and not to a side group. For the purposes of the present disclosure, a side group is a monovalent radical that when theoretically or actually removed from the polymer does not shorten the length of the polymer chain. The sulfonated thiophene polymer and/or copolymer may be made using any method known to those of ordinary skill in the art. For example, the polythiophene may be sulfonated by reacting the polythiophene with a sulfonating reagent such as, for example, fuming sulfuric acid, acetyl sulfate, pyridine $SO_3$, or the like. In another example, monomers may be sulfonated using a sulfonating reagent and then polymerized according to known methods and/or methods described herein. It would be understood by the ordinarily-skilled artisan that sulfonic acid groups in the presence of a basic compound, for example, alkali metal hydroxides, ammonia, and alkylamines, such as, for example, mono-, di-, and trialkylamines, such as, for example, triethylamine, may result in the formation of the corresponding salt or adduct. Thus, the term "sulfonated" in relation to the polythiophene includes the meaning that the polythiophene may comprise one or more $-SO_3M$ groups, wherein M may be an alkali metal ion, such as, for example, $Na^+$, $Li^+$, $K^+$, $Rb^+$, $Cs^+$; ammonium ($NH_4^+$), mono-, di-, and trialkylammonium, such as triethylammonium.

The sulfonation of conjugated polymers and sulfonated conjugated polymers, including sulfonated polythiophenes, are described in U.S. Patent No. 8,017,241 to Seshadri et al., which is incorporated herein by reference in its entirety.

In an embodiment, the polythiophene is sulfonated.

In an embodiment, the polythiophene is sulfonated poly(3-MEET).

The polythiophene used according to the present disclosure may be homopolymers or copolymers, including statistical, random, gradient, and block copolymers. For a polymer comprising a monomer A and a monomer B, block copolymers include, for example, A-B diblock copolymers, A-B-A triblock copolymers, and $-(AB)_n-$multiblock copolymers. The polythiophene may comprise repeating units derived from other types of monomers such as, for example, thienothiophenes, selenophenes, pyrroles, furans, tellurophenes, anilines, arylamines, and arylenes, such as, for example, phenylenes, phenylene vinylenes, and fluorenes.

In an embodiment, the polythiophene comprises repeating units complying with formula (I) in an amount of greater than 50% by weight, typically greater than 80% by weight, more typically greater than 90% by weight, even more typically greater than 95% by weight, based on the total weight of the repeating units.

It would be clear to a person of ordinary skill in the art that, depending on the purity of the starting monomer compound(s) used in the polymerization, the polymer formed may contain repeating units derived from impurities. As used herein, the term "homopolymer" is intended to mean a polymer comprising repeating units derived from one type of monomer, but may contain repeating units derived from impurities. In an embodiment, the polythiophene is a homopolymer wherein essentially all of the repeating units are repeating units complying with formula (I).

The polythiophene typically has a number average molecular weight between about 1,000 and 1,000,000 g/mol. More typically, the conjugated polymer has a number average molecular weight between about 5,000 and 100,000 g/mol, even more typically about 10,000 to about 50,000 g/mol. Number average molecular weight may be determined according to methods known to those of ordinary skill in the art, such as, for example, by gel permeation chromatography.

In an embodiment, the polythiophene is used after treatment with a reducing agent.

In a conjugated polymer such as a polythiophene, the chemical structure of some of the repeating units constituting it may be an oxidized structure called a "quinoid structure." The term "quinoid structure" is used as opposed to the term "benzenoid structure"; whereas the latter is a structure comprising an aromatic ring, the former refers to a structure in which double bond(s) in the aromatic ring have moved out of the ring (as a result of which the aromatic ring disappears), thereby forming two double bonds outside the ring that are conjugated to the other double bond(s) remaining in the ring. Those skilled in the art will readily appreciate the relationship between these two structures from the relationship between the structures of benzoquinone and hydroquinone. The quinoid structures for the repeating units of various conjugated polymers are well known to those skilled in the art. The quinoid structure corresponding to the repeating unit of the polythiophene represented by formula (I) above is shown in the following formula (I').

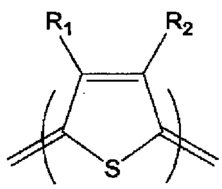

(I')

wherein $R_1$ and $R_2$ are as defined in formula (I).

This quinoid structure forms part of the structures called the "polaron structure" and the "bipolaron structure" that are generated by the doping reaction described above and impart charge transportability to a conjugated polymer such as a polythiophene. These structures are known. The introduction of the "polaron structure" and/or the "bipolaron structure" is essential in the fabrication of an organic EL device, and in fact, this is achieved by intentionally causing the above-mentioned doping reaction to occur when the charge transporting film formed from a charge transporting varnish is baked during the fabrication of an organic EL device. The presence of the quinoid structure in a conjugated polymer before causing the doping reaction to occur is believed to be attributable to an unintended oxidation reaction that is equivalent to the doping reaction and is undergone by the conjugated polymer in the manufacturing process thereof (the sulfonation step thereof in particular, if the conjugated polymer is sulfonated).

There is a correlation between the amount of quinoid structure contained in a polythiophene and the dispersibility of the polythiophene in an organic solvent; as the amount of quinoid structure increases, the dispersibility decreases. Therefore, whereas the introduction of a quinoid structure after the formation of a charge transporting film from the non-aqueous ink composition does not cause a problem, if an excess amount of quinoid structure is introduced into the polythiophene by the above-mentioned unintended oxidation reaction, it negatively affects the production of the non-aqueous ink composition. Polythiophenes are, in some cases, known to show product-by-product variation in dispersibility in organic solvents, and it is believed that one of the reasons for this is because the amount of quinoid structure introduced into the polythiophene by the unintentional oxidation reaction varies depending on the difference in the production conditions for different polythiophenes.

Accordingly, subjecting the polythiophene to reduction treatment using a reducing agent decreases, through reduction, the amount of quinoid structure, even if there was excessive quinoid structure in the polythiophene at first.

This improves the dispersibility of the polythiophene in an organic solvent, thereby allowing for stable production of a good non-aqueous ink composition that provides a charge transporting film having excellent homogeneity.

The reducing agent used in this reduction treatment is not particularly limited as long as it can convert, through reduction, the polythiophene quinoid structure represented by formula (I') above into a non-oxidized structure, i.e., the polythiophene benzenoid structure represented by formula (I) above, and for example, ammonia water, hydrazine, or the like are preferably used. The amount of reducing agent is typically from 0.1 to 10 parts by weight, preferably from 0.5 to 2 parts by weight, based on 100 parts by weight of the polythiophene to be treated.

There are no particular restrictions on the method and conditions for the reduction treatment. This treatment can be carried out, for example, simply by contacting the polythiophene with a reducing agent in the presence or absence of a suitable solvent. Typically, reduction treatment under relatively mild conditions, such as stirring the polythiophene in 28% aqueous ammonia (e.g., overnight at room temperature), substantially improves the dispersibility of the polythiophene in an organic solvent.

If the polythiophene is sulfonated, the sulfonated polythiophene may as appropriate be converted to a corresponding ammonium salt, e.g., a trialkylammonium salt (an amine adduct of the sulfonated polythiophene) prior to subjecting it to reduction treatment.

A polythiophene that was not dissolved in the reaction system at the start of the treatment may be dissolved at the completion of the treatment, as a result of a change in the dispersibility of the polythiophene in the solvent caused by the reduction treatment. In such cases, the polythiophene can be recovered, for example, by adding an organic solvent incompatible with the polythiophene (such as acetone, isopropyl alcohol, etc.) to the reaction system to cause precipitation of the polythiophene before subjecting it to filtration.

The non-aqueous ink composition of the present disclosure may optionally further comprise other hole carrier compounds.

Optional hole carrier compounds include, for example, low molecular weight compounds or high molecular weight compounds. The optional hole carrier compounds may be non-polymeric or polymeric. Non-polymeric hole carrier compounds include, but are not limited to, cross-linkable and non-crosslinked small molecules. Examples of non-polymeric hole carrier compounds include, but are not limited to, N,N'-bis(3-methylphenyl)-N,N'-bis(phenyl)benzidine (CAS # 65181-78-4); N,N'-bis(4-methylphenyl)-N,N'-bis(phenyl)benzidine; N,N'-bis(2-naphtalenyl)-N-N'-bis(phenylbenzidine) (CAS # 139255-17-1); 1,3,5-tris(3-methyldiphenylamino)benzene (also referred to as m-MTDAB); N,N'-bis(1-naphtalenyl)-N,N'-bis(phenyl)benzidine (CAS # 123847-85-8, NPB); 4,4',4"-tris(N,N-phenyl-3-methylphenylamino)triphenylamine (also referred to as m-MTDATA, CAS # 124729-98-2); 4,4',N,N'-diphenylcarbazole (also referred to as CBP, CAS # 58328-31-7); 1,3,5-tris(diphenylamino)benzene; 1,3,5-tris(2-(9-ethylcarbazyl-3)ethylene)benzene; 1,3,5-tris[(3-methylphenyl)phenylamino]benzene; 1,3-bis(N-carbazolyl)benzene; 1,4-bis(diphenylamino)benzene; 4,4'-bis(N-carbazolyl)-1,1'-biphenyl; 4,4'-bis(N-carbazolyl)-1,1'-biphenyl; 4-(dibenzylamino)benzaldehyde-N,N-diphenylhydrazone; 4-(diethylamino)benzaldehyde diphenylhydrazone; 4-(dimethylamino)benzaldehyde diphenylhydrazone; 4-(diphenylamino)benzaldehyde diphenylhydrazone; 9-ethyl-3-carbazolecarboxaldehyde diphenylhydrazone; copper(II) phthalocyanine; N,N'-bis(3-methylphenyl)-N,N'-diphenylbenzidine; N,N'-di-[(1-naphthyl)-N,N'-diphenyl]-1,1'-biphenyl)-4,4'-diamine; N,N'-diphenyl-N,N'-di-p-tolylbenzene-1,4-diamine; tetra-N-phenylbenzidine; titanyl phthalocyanine; tri-p-tolylamine; tris(4-carbazol-9-ylphenyl)amine; and tris[4-(diethylamino)phenyl]amine.

Optional polymeric hole carrier compounds include, but are not limited to, poly[(9,9-dihexylfluorenyl-2,7-diyl)-alt-co-(N,N'-bis{p-butylphenyl}-1,4-diaminophenylene)]; poly[(9,9-dioctylfluorenyl-2,7-diyl)-alt-co-(N,N'-bis {p-butylphenyl}-1,1'-biphenylene-4,4'-diamine)]; poly(9,9-dioctylfluorene-co-N-(4-butylphenyl)diphenylamine) (also referred to as TFB) and poly[N,N'-bis(4-butylphenyl)-N,N'-bis(phenyl)-benzidine] (commonly referred to as poly-TPD).

Other optional hole carrier compounds are described in, for example, US Patent Publications 2010/0292399 published Nov. 18, 2010; 2010/010900 published May 6, 2010; and 2010/ 0108954 published May 6, 2010. Optional hole carrier compounds described herein are known in the art and are commercially available.

The polythiophene comprising a repeating unit complying with formula (I) may or may not be doped.

In an embodiment, the polythiophene comprising a repeating unit complying with formula (I) is doped with a dopant. Dopants are known in the art. See, for example, U.S. Patent 7,070,867; US Publication 2005/0123793; and US Publication 2004/0113127. The dopant can be an ionic compound. The dopant can comprise a cation and an anion. One or more dopants may be used to dope the polythiophene comprising a repeating unit complying with formula (I).

The cation of the ionic compound can be, for example, V, Cr, Mn, Fe, Co, Ni, Cu, Nb, Mo, Tc, Ru, Rh, Pd, Ag, Ta, W, Re, Os, Ir, Pt, or Au.

The cation of the ionic compound can be, for example, gold, molybdenum, rhenium, iron, and silver cation.

In some embodiments, the dopant can comprise a sulfonate or a carboxylate, including alkyl, aryl, and heteroaryl sulfonates and carboxylates. As used herein, "sulfonate" refers to a $-SO_3M$ group, wherein M may be $H^+$ or an alkali metal ion, such as, for example, $Na^+$, $Li^+$, $K^+$, $Rb^+$, $Cs^+$; or ammonium ($NH_4^+$). As used herein, "carboxylate" refers to a $-CO_2M$ group, wherein M may be $H^+$ or an alkali metal ion, such as, for example, $Na^+$, $Li^+$, $K^+$, $Rb^+$, $Cs^+$; or ammonium ($NH_4^+$). Examples of sulfonate and carboxylate dopants include, but are not limited to, benzoate compounds, heptafluorobutyrate, methanesulfonate, trifluoromethanesulfonate, p-toluenesulfonate, pentafluoropropionate, and polymeric sulfonates, perfluorosulfonate-containing ionomers, and the like.

In some embodiments, the dopant does not comprise a sulfonate or a carboxylate.

In some embodiments, dopants may comprise sulfonylimides, such as, for example, bis(trifluoromethanesulfonyl)imide; antimonates, such as, for example, hexafluoroantimonate; arsenates, such as, for example, hexafluoroarsenate; phosphorus compounds, such as, for example, hexafluorophosphate; and borates, such as, for example, tetrafluoroborate, tetraarylborates, and trifluoroborates. Examples of tetraarylborates include, but are not limited to, halogenatedtetraarylborates, such as tetrakispentafluorophenylborate (TPFB). Examples of trifluoroborates include, but are not limited to, (2-nitrophenyl)trifluoroborate, benzofurazan-5-trifluoroborate, pyrimidine-5-trifluoroborate, pyridine-3-trifluoroborate, and 2,5-dimethylthiophene-3-trifluoroborate.

As described herein, the polythiophene may be doped with a dopant. The dopant can be, for example, a material that will undergo, for example, one or more electron transfer reaction(s) with a polythiophene, thereby yielding a doped polythiophene. The dopant can be selected to provide a suitable charge balancing counter-anion. A reaction can occur upon mixing of the polythiophene and the dopant as known in the art. For example, the dopant may undergo spontaneous electron transfer from the polymer to a cation-anion dopant, such as a metal salt, leaving behind a conjugated polymer in its oxidized form with an associated anion and free metal. See, for example, Lebedev et al., Chem. Mater., 1998, 10, 156-163. As disclosed herein, the polythiophene and the dopant can refer to components that will react to form a doped polymer. The doping reaction can be a charge transfer reaction, wherein charge carriers are generated, and the reaction can be reversible or irreversible. In some embodiments, silver ions may undergo electron transfer to or from silver metal and the doped polymer.

In the final formulation, the composition can be distinctly different from the combination of original components (i.e., polythiophene and/or dopant may or may not be present in the final composition in the same form as before mixing).

Some embodiments allow for removal of reaction by-products from the doping process. For example, the metals, such as silver, can be removed by filtration.

Materials can be purified to remove, for example, halogens and metals. Halogens include, for example, chloride, bromide and iodide. Metals include, for example, the cation of the dopant, including the reduced form of the cation of the dopant, or metals left from catalyst or initiator residues. Metals include, for example, silver, nickel, and magnesium. The amounts can be less than, for example, 100 ppm, or less than 10 ppm, or less than 1 ppm.

Metal content, including silver content, can be measured by ICP-MS, particularly for concentrations greater than 50 ppm.

In an embodiment, when the polythiophene is doped with a dopant, the polythiophene and the dopant are mixed to form a doped polymer composition. Mixing may be achieved using any method known to those of ordinary skill in the art. For example, a solution comprising the polythiophene may be mixed with a separate solution comprising the dopant. The solvent or solvents used to dissolve the polythiophene and the dopant may be one or more solvents described herein. A reaction can occur upon mixing of the polythiophene and the dopant as known in the art. The resulting doped polythiophene composition comprises between about 40% and 75% by weight of the polymer and between about 25% and 55% by weight of the dopant, based on the composition. In another embodiment, the doped polythiophene composition comprises between about 50% and 65% for the polythiophene and between about 35% and 50% of the dopant, based on the composition. Typically, the amount by weight of the polythiophene is greater than the amount by weight of the dopant. Typically, the dopant can be a silver salt, such as silver tetrakis(pentafluorophenyl)borate in an amount of about 0.25 to 0.5 m/ru, wherein m is the molar amount of silver salt and ru is the molar amount of polymer repeat unit.

The doped polythiophene is isolated according to methods known to those of ordinary skill in the art, such as, for example, by rotary evaporation of the solvent, to obtain a dry or substantially dry material, such as a powder. The amount of residual solvent can be, for example, 10 wt. % or less, or 5 wt. % or less, or 1 wt. % or less, based on the dry or substantially dry material. The dry or substantially dry powder can be redispersed or redissolved in one or more new solvents.

The non-aqueous ink composition of the present invention comprises metal oxide nanoparticles. The metal oxide nanoparticles (b) used in the present invention comprise at least (b-1) and (b-2) below:

(b-1) a first metal oxide nanoparticle having an average primary particle diameter $d_1$ (hereafter sometimes referred to as "component (b-1)")
(b-2) a second metal oxide nanoparticle having an average primary particle diameter $d_2$ (hereafter sometimes referred to as "component (b-2)"),
wherein the average primary particle diameters $d_1$ and $d_2$ satisfy the relation $d_1<d_2$.

As used herein, "metalloid" refers to an element having chemical and/or physical properties intermediate of, or that are a mixture of, those of metals and nonmetals. As used herein, "metalloid" refers to boron (B), silicon (Si), germanium (Ge), arsenic (As), antimony (Sb), and tellurium (Te).

As used herein, "metal oxide" refers to an oxide of one or a combination of two or more selected from metals such as tin (Sn), titanium (Ti), aluminum (Al), zirconium (Zr), zinc (Zn), niobium (Nb), tantalum (Ta), and W (tungsten), and the above-mentioned metalloids.

As used herein, the term "nanoparticle" refers to a nanoscale particle, the primary particle average diameter (average primary particle diameter) of which is typically 500 nm or less. The primary particle average diameter can be obtained by converting the specific surface area obtained by the BET method.

When converting the specific surface area obtained by the BET method, the average particle diameter can be calculated by the following equation, assuming that the particles are true spheres.

$$d = 6{,}000 / (S \times \rho)$$

d: Average particle diameter (nm)
S: Specific surface area ($m^2/g$)
p: True specific gravity ($g/cm^3$)

The BET method relies on the adsorption of gas molecules to the particle surface, and is based on the assumption that gas molecules adsorb on the entire particle surface. Therefore, the BET method is difficult to apply, if there is a region on the particle surface that is not available for adsorption of gas molecules. One example of this is nanoparticles that undergo heavy aggregation, and this often results from a small particle diameter, e.g., 7 nm or less. In cases like this, the primary particle average diameter may be measured by a method other than the BET method. Examples of such methods include sodium hydroxide titration (See, e.g., George W. Sears Jr., Anal. Chem. 28 (12), pp. 1981-1983 (1956)).

As used herein, the primary particle average particle diameter of a metal oxide nanoparticle, unless otherwise specified, represents a value measured by converting the specific surface area obtained by the BET method.

The primary particle average diameter of the metal oxide nanoparticles described herein is less than or equal to 500 nm; less than or equal to 250 nm; less than or equal to 100 nm; or less than or equal to 50 nm; or less than or equal to 25 nm. Typically, the metal oxide nanoparticles have a number average primary particle diameter from about 1 nm to about 100 nm, more typically from about 2 nm to about 30 nm. As described above, however, with respect to component (b-1) and component (b-2) described above, which the metal oxide nanoparticles (b) used in the present invention at least comprises, the average primary particle diameter $d_1$ of the former and the average primary particle diameter $d_2$ of the latter satisfy the relation $d_1 < d_2$.

As described above, when a non-aqueous ink composition is applied to a substrate by an ink jetting method to form a charge transporting film, even using a substrate having a liquid repellent bank as the substrate may not be able to prevent the pile-up phenomenon, resulting in the obtained charge transporting film having non-uniform thickness. The present inventors have discovered that a non-aqueous ink composition comprising metal oxide nanoparticles is particularly prone to this kind of pile-up phenomenon. Although the cause has not been elucidated, it is believed that the pile-up phenomenon occurs because the metal oxide nanoparticles dispersed in the non-aqueous ink composition migrate to the side of the bank and proceed to climb along the bank during the drying process, as a result of certain interactions with other components in the composition, the substrate surface, or the side of the bank.

This prompted the present inventors to examine the relationship between the behavior of the metal oxide nanoparticles in the non-aqueous ink composition and the pile-up phenomenon, which led to the discovery that the more uniform the state of dispersion of the metal oxide nanoparticles in the non-aqueous ink composition, the more pronounced the occurrence of the pile-up phenomenon; that is, there is a correlation between the state of dispersion of the metal oxide nanoparticles in the non-aqueous ink composition and the occurrence of the pile-up phenomenon. This suggests that the pile-up phenomenon can be suppressed by appropriately controlling the state of dispersion.

The state of dispersion of the metal oxide nanoparticles in the non-aqueous ink composition is believed to reflect the particle size distribution of the metal oxide nanoparticles; the narrower the particle size distribution, the more uniform the state of dispersion of the metal oxide nanoparticles becomes. This led to the inference that an excessively narrow particle size distribution of the metal oxide nanoparticles is likely to give rise to the pile-up phenomenon, while a moderate widening of the particle size distribution allows the state of dispersion to be controlled appropriately, thereby suppressing the pile-up phenomenon.

Based on this inference, the present inventors have conducted further study using different metal oxide nanoparticles having various characteristics, and have found that, surprisingly, the pile-up phenomenon can be suppressed effectively by making sure that the metal oxide nanoparticles have a particle size distribution that encompasses particles having a particle diameter of about 4 nm to 80 nm, more preferably about 5 nm to 40 nm, and more preferably about 10 nm to 20 nm. A moderately wide particle size distribution for the metal oxide nanoparticles can be obtained by combining

two or more kinds of metal oxide nanoparticles having different average primary particle diameters. Although the mechanism of suppression of the pile-up phenomenon has not been clarified in detail, it is possible that contributions arise, for example, from the differences in the behavior exhibited under the conditions described above between components (b-1) and (b-2) described above due to the difference in the average primary particle diameter, and from interactions (e.g., aggregation) between components (b-1) and (b-2) described above that would not be not present when they were not used in combination.

As described above, attempts to suppress the pile-up phenomenon without using such metal oxide nanoparticles as described above may in some cases tend to have the opposite effect of deteriorating certain characteristics of organic EL devices. The present inventors have found, however, that when the non-aqueous ink composition of the present invention comprising the metal oxide nanoparticles described above, in particular, a non-aqueous ink composition further comprising an amine compound is used to form a charge transporting film, which in turn is used to fabricate an organic EL device, surprisingly, the deterioration in characteristics of the obtained organic EL device is not as pronounced as when conventional metal oxide nanoparticles are used, and in particular, the deterioration in current efficiency is suppressed. Although the mechanism has not been clarified in detail, the present inventors have found out that when an amine compound is added to the non-aqueous ink composition comprising the metal oxide nanoparticles described above, there is less residue of the amine compound in the obtained charge transporting film than when conventional metal oxide nanoparticles are used, leading to the inference that this contributes to the suppression of deterioration in characteristics (e.g., current efficiency) of the organic EL device. This may be caused by interactions between components (b-1) and (b-2) described above that would not be present when they were not used in combination.

Thus, the non-aqueous ink composition of the present invention, in which metal oxide nanoparticles comprising two or more kinds of metal oxide nanoparticles having mutually different average primary particle diameters are added to a specific combination of a polythiophene and a liquid carrier, can suppress pile-up while avoiding an excessive deterioration in organic EL device characteristics. In other words, the metal oxide nanoparticles (b) described above can be used as a pile-up suppressor; addition of the metal oxide nanoparticles (b) to a non-aqueous ink composition results in the suppression of the pile up phenomenon that occurs when a charge transporting film is formed by applying to a substrate having a liquid repellent bank, and drying, the non-aqueous ink composition. As described above, since the uneven thickness of a charge transporting film caused by the pile-up phenomenon may shorten the lifetime of an organic EL device, this suppression of the pile-up phenomenon can extend the lifetime of the organic EL device.

The metal oxide nanoparticles (b) may optionally further comprise other metal oxide nanoparticles in addition to component (b-1) and component (b-2) described above. These metal oxide nanoparticles may be composed of the same chemical species or may be each composed of different chemical species. In the present invention, it is preferable to combine two kinds of metal oxide nanoparticles having mutually different average primary particle diameters, and it is more preferable to combine two kinds of metal oxide nanoparticles that are composed of the same chemical species and are different from each other only in average primary particle diameter.

With respect to the average primary particle diameter $d_1$ of the first metal oxide nanoparticle (b-1) and the average primary particle diameter $d_2$ ($d_1 < d_2$) of the second metal oxide nanoparticle (b-2), which the metal oxide nanoparticles (b) at least comprise, preferably, $d_1$ is less than 15 nm, and the average primary particle diameter d2 is equal to or greater than 10 nm; more preferably, $d_1$ is equal to or greater than 3 nm and less than 15 nm, and the average primary particle diameter $d_2$ is equal to or greater than 10 nm and equal to or less than 30 (or 50) nm.

In addition, it is preferable that component (b-1) and component (b-2), which the metal oxide nanoparticles (b) at least comprise, preferably satisfy a relation expressed by a specific equation for the ratio of the average primary particle diameter $d_2$ of the latter to the average primary particle diameter $d_1$ ($d_1 < d_2$) of the former, i.e., $d_2/d_1$. $d_1$ and $d_2$ preferably satisfy the relation expressed by the equation $d_2/d_1 > 1.5$, and more preferably satisfy the relation expressed by the formula $d_2/d_1 > 2.0$. Although there is no particular upper limit to the value of the ratio $d_2/d_1$, $d_1$ and $d_2$ preferably satisfy the relation expressed by the equation $d_2/d_1 < 1{,}000$, and more preferably satisfy the relation expressed by the equation $d_2/d_1 < 100$.

In the metal oxide nanoparticles (b), the weight ratio (b-1)/(b-2) of the first metal oxide nanoparticle (b-1) to the second metal oxide nanoparticle (b-2) is preferably in the range of 0.001 to 1,000, more preferably in the range of 0.01 to 100.

Metal oxide nanoparticles suitable for use according to the present invention include nanoparticles of oxides of boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta), and W (tungsten), etc., or mixed oxides containing these. Non-limiting specific examples of suitable metal oxide nanoparticles include, but are not limited to, nanoparticles comprising $B_2O_3$, $B_2O$, $SiO_2$, $SiO$, $GeO_2$, $GeO$, $As_2O_4$, $As_2O_3$, $As_2O_5$, $Sb_2O_3$, $Sb_2O_5$, $TeO_2$, $SnO_2$, $ZrO_2$, $Al_2O_3$, $ZnO$ and mixtures thereof.

In an embodiment, component (b-1) and component (b-2) each, independently, comprise $B_2O_3$, $B_2O$, $SiO_2$, $SiO$, $GeO_2$, $GeO$, $As_2O_4$, $As_2O_3$, $As_2O_5$, $SnO_2$, $SnO$, $Sb_2O_3$, $TeO_2$, or mixtures thereof.

In an embodiment, component (b-1) and component (b-2) both comprise $SiO_2$.

The metal oxide nanoparticles may comprise one or more organic capping groups. Such organic capping groups may be reactive or non-reactive. Reactive organic capping groups are organic capping groups capable of cross-linking, for example, in the presence of UV radiation or radical initiators.

In an embodiment, the metal oxide nanoparticles comprise one or more organic capping groups.

Examples of suitable metal oxide nanoparticles include $SiO_2$ nanoparticles available as dispersions in various solvents, such as, for example, methyl ethyl ketone, methyl isobutyl ketone, *N*,*N*-dimethylacetamide, ethylene glycol, 2-propanol, methanol, ethylene glycol monopropyl ether, and propylene glycol monomethyl ether acetate, marketed by Nissan Chemical Industries, Ltd.

The amount of the metal oxide nanoparticles used in the non-aqueous ink composition described herein can be controlled and measured as a weight percentage relative to the combined weight of the metal oxide nanoparticles and the doped or undoped polythiophene. In an embodiment, the amount of the metal oxide nanoparticles is from 1 wt. % to 98 wt. %, typically from about 2 wt. to about 95 wt. %, more typically from about 5 wt. % to about 90 wt. %, still more typically about 10 wt. % to about 90 wt. %, relative to the combined weight of the metal oxide nanoparticles and the doped or undoped polythiophene. In an embodiment, the amount of the metal oxide nanoparticles is from about 20 wt. % to about 98 wt. %, typically from about 25 wt. to about 95 wt. %, relative to the combined weight of the metal oxide nanoparticles and the doped or undoped polythiophene.

The liquid carrier used in the non-aqueous ink composition according to the present invention comprises one or more organic solvents. In an embodiment, the liquid carrier consists essentially of or consists of one or more organic solvents. The liquid carrier may be an organic solvent or solvent blend comprising two or more organic solvents adapted for use and processing with other layers in a device such as the anode or light emitting layer.

Organic solvents suitable for use in the liquid carrier include, but are not limited to, aliphatic and aromatic ketones, organosulfur solvents, such as dimethyl sulfoxide (DMSO) and 2,3,4,5-tetrahydrothiophene-1,1-dioxide (tetramethylene sulfone; Sulfolane), tetrahydrofuran (THF), tetrahydropyran (THP), tetramethyl urea (TMU), *N*,*N'*-dimethylpropyleneurea, alkylated benzenes, such as xylene and isomers thereof, halogenated benzenes, *N*-methylpyrrolidinone (NMP), dimethylformamide (DMF), dimethylacetamide (DMAc), dichloromethane, acetonitrile, dioxanes, ethyl acetate, ethyl benzoate, methyl benzoate, dimethyl carbonate, ethylene carbonate, propylene carbonate, 3-methoxypropionitrile, 3-ethoxypropionitrile, or combinations thereof.

Aliphatic and aromatic ketones include, but are not limited to, acetone, acetonyl acetone, methyl ethyl ketone (MEK), methyl isobutyl ketone, methyl isobutenyl ketone, 2-hexanone, 2-pentanone, acetophenone, ethyl phenyl ketone, cyclohexanone, and cyclopentanone. In some embodiments, ketones with protons on the carbon located alpha to the ketone are avoided, such as cyclohexanone, methyl ethyl ketone, and acetone.

Other organic solvents might also be considered that solubilize, completely or partially, the polythiophene or that swell the polythiophene. Such other solvents may be included in the liquid carrier in varying quantities to modify ink properties such as wetting, viscosity, morphology control. The liquid carrier may further comprise one or more organic solvents that act as non-solvents for the polythiophene.

Other organic solvents suitable for use according to the present invention include ethers such as anisole, ethoxybenzene, dimethoxy benzenes and glycol diethers (glycol diethers), such as, ethylene glycol diethers (such as 1,2-dimethoxyethane, 1,2-diethoxyethane, and 1,2-dibutoxyethane); diethylene glycol diethers such as diethylene glycol dimethyl ether, and diethylene glycol diethyl ether; propylene glycol diethers such as propylene glycol dimethyl ether, propylene glycol diethyl ether, and propylene glycol dibutyl ether; dipropylene glycol diethers, such as dipropylene glycol dimethyl ether, dipropylene glycol diethyl ether, and dipropylene glycol dibutyl ether; as well as higher analogues (i.e., tri- and tetra- analogues, e.g., triethylene glycol dimethyl ether, triethylene glycol butyl methyl ether, tetraethylene glycol dimethyl ether, etc.) of the ethylene glycol and propylene glycol ethers mentioned herein.

Still other solvents can be considered, such as ethylene glycol monoether acetates and propylene glycol monoether acetates (glycol ester ethers), wherein the ether can be selected, for example, from methyl, ethyl, n-propyl, isopropyl, n-butyl, sec-butyl, tert-butyl, and cyclohexyl; as well as higher glycol ether analogues of the above list (such as di-, tri- and tetra-).

Examples include, but are not limited to, propylene glycol methyl ether acetate, 2-ethoxyethyl acetate, 2-butoxyethyl acetate, ethylene glycol monomethyl ether acetate, and diethylene glycol monomethyl ether acetate.

Still other solvents such as ethylene glycol diacetate (glycol diesters) can be considered, which include higher glycol ether analogues (such as di-, tri- and tetra-).

Examples include, but are not limited to, ethylene glycol diacetate, triethylene glycol diacetate, and propylene glycol diacetate.

Alcohols may also be considered for use in the liquid carrier, such as, for example, methanol, ethanol, trifluoroethanol, n-propanol, isopropanol, n-butanol, t-butanol, and and alkylene glycol monoethers (glycol monoethers). Examples of suitable glycol monoethers include, but are not limited to, ethylene glycol monopropyl ether, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), ethylene glycol monobutyl ether (butyl Cellosolve),

diethylene glycol monobutyl ether (butyl Carbitol), dipropylene glycol monomethyl ether (Dowanol DPM), diisobutyl carbinol, 2-ethylhexyl alcohol, methyl isobutyl carbinol, propylene glycol monopropyl ether (Dowanol PnP), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

As disclosed herein, the organic solvents disclosed herein can be used in varying proportions in the liquid carrier, for example, to improve ink characteristics such as substrate wettability, ease of solvent removal, viscosity, surface tension, and jettability.

In some embodiments, the use of aprotic non-polar solvents can provide the additional benefit of increased life-times for devices with emitter technologies which are sensitive to protons, such as, for example, PHOLEDs.

In an embodiment, the liquid carrier comprises dimethyl sulfoxide, ethylene glycol (glycols), tetramethyl urea, or a mixture thereof.

Examples of suitable glycols include, but are not limited to, ethylene glycol, diethylene glycol, dipropylene glycol, polypropylene glycol, propylene glycol, triethylene glycol, and the like.

The above-mentioned glycol diethers, glycol ester ethers, glycol diesters, glycol monoethers, glycol monoethers, glycols, and the like are collectively referred to as "glycol-based solvents." That is, a "glycol-based solvent" as used herein is an organic solvent that does not have one or more aromatic structures and is represented by the formula $R^1$-O-(R-O)$_n$-$R^2$, wherein each R is, independently, a linear $C_2$-$C_4$ unsubstituted alkylene group; $R^1$ and $R^2$ are each, independently, a hydrogen atom, a linear, branched, or cyclic $C_1$-$C_8$ unsubstituted alkyl group, or a linear or branched $C_1$-Cs unsubstituted aliphatic acyl group; and n is an integer of 1 to 6. It is particularly preferable that R is a $C_2$ or $C_3$ unsubstituted alkylene group. It is particularly preferable that n is an integer of 1 to 4. As the alkyl group, a linear, branched or cyclic $C_1$-$C_6$ unsubstituted alkyl group is preferable, a linear $C_1$-$C_4$ unsubstituted alkyl group is more preferable, and a methyl group and an n-butyl group are particularly preferable. As the acyl group, a linear or branched $C_2$-$C_6$ unsubstituted aliphatic acyl group is preferable, a linear $C_2$-$C_4$ unsubstituted acyl group is more preferable, and an acetyl group and a propionyl group are particularly preferable. Such glycol-based solvents include, for example, the following solvents.

- Glycols which are ethylene glycol, propylene glycol or oligomers thereof (dimers to tetramers, e.g. diethylene glycol)
- Glycol monoethers which are mono alkyl ethers of the aforementioned glycols
- Glycol diethers which are dialkyl ethers of the aforementioned glycols
- Glycol monoesters which are aliphatic carboxylic acid monoesters of the aforementioned glycols
- Glycol diesters which are aliphatic carboxylic acid diesters of the aforementioned glycols
- Glycol ester ethers which are aliphatic carboxylic acid monoesters of the aforementioned glycol monoethers

For ease of application by inkjet coating, it is preferable to use a liquid carrier comprising a glycol-based solvent.

Hereinafter, glycol-based solvents may be contrasted with organic solvents not falling under this category, and, for convenience, the former may be denoted by (A) and the latter may be denoted by (B).

In an embodiment, the liquid carrier is a liquid carrier consisting of one or more glycol-based solvents (A).

In cases where the liquid carrier is a liquid carrier consisting of one or more glycol-based solvents (A), preferable examples of glycol-based solvents (A) include glycol diethers, glycol monoethers, and glycols, as well as mixtures thereof. Examples include, but are not limited to, mixtures of the following three types: glycol monoethers, glycol diethers and glycols.

Specific examples include the above-mentioned examples of glycol monoethers, glycol diethers and glycols; preferable examples of glycol monoethers include diethylene glycol monobutyl ether; preferable examples of glycol diethers include triethylene glycol dimethyl ether and triethylene glycol butyl methyl ether; and preferable examples of glycols include ethylene glycol and diethylene glycol.

In cases where the liquid carrier is a liquid carrier consisting of one or more glycol-based solvents (A), the glycols are preferably 30% or more, and from the perspective of solubility of the polythiophene, more preferably 40% or more, and even more preferably 50% or more, with respect to the liquid carrier.

In an embodiment, the liquid carrier is a liquid carrier comprising one or more glycol-based solvents (A) and one or more organic solvents other than glycol-based solvents (B). In this case, preferable examples of glycol-based solvents (A) include those listed above, and more preferable examples include glycol diethers and glycols, as well as mixtures thereof. Examples include, but are not limited to, mixtures of the following two types: glycol diethers and glycols.

Specific examples include the above-mentioned examples of glycol diethers and glycols; preferable examples of glycol diethers include triethylene glycol dimethyl ether and triethylene glycol butyl methyl ether; and preferable examples of glycols include ethylene glycol and diethylene glycol.

Preferable examples of organic solvents (B) include nitriles, alcohols, aromatic ethers, and aromatic hydrocarbons.

Examples of nitriles include, but are not limited to, methoxypropionitrile and ethoxypropionitrile. Examples of

alcohols include, but are not limited to, benzyl alcohol, and 2-(benzyloxy)ethanol. Examples of aromatic ethers include, but are not limited to, methyl anisole, dimethyl anisole, ethyl anisole, butyl phenyl ether, butyl anisole, pentyl anisole, hexyl anisole, heptyl anisole, octyl anisole, phenoxy toluene. Examples of aromatic hydrocarbons include, but are not limited to, pentylbenzene, hexylbenzene, heptylbenzene, octylbenzene, nonylbenzene, cyclohexylbenzene, and tetralin.

Among these, alcohols are more preferable, and 2-(benzyloxy)ethanol is more preferable among the alcohols.

Addition of an organic solvent (B) to a glycol-based solvent (A) allows proper control, at the time of film formation by inkjet coating, of the aggregation of the metal oxide nanoparticles while maintaining the solubility of the solids in the ink, thereby enabling a flatter film to be formed.

When the organic solvent (B) is added to the glycol-based solvent (A), the amount of glycol-based solvent (A): wtA (in weight) and the amount of organic solvent (B): wtB (in weight) preferably satisfy formula (1-1), more preferably satisfy formula (1-2), and most preferably satisfy formula (1-3).

$$0.05 \leq wtB / (wtA + wtB) \leq 0.50 \qquad (1\text{-}1)$$

$$0.10 \leq wtB / (wtA + wtB) \leq 0.40 \qquad (1\text{-}2)$$

$$0.10 \leq wtB / (wtA + wtB) \leq 0.30 \qquad (1\text{-}3)$$

Where the composition of the present invention comprises two or more glycol-based solvents (A), wtA indicates the total amount (in weight) of glycol-based solvents (A); where the composition of the present invention comprises two or more organic solvents (B), wtB indicates the total amount (in weight) of organic solvents (B).

The amount of liquid carrier in the non-aqueous ink composition according to the present invention is from about 50 wt. % to about 99 wt. %, typically from about 75 wt. % to about 98 wt. %, still more typically from about 90 wt. % to about 95 wt. %, with respect to the total amount of ink composition.

As will be described below, the non-aqueous ink composition according to the present invention may be prepared by mixing components such as a polythiophene in the form of a solution or a dispersion in an organic solvent (a stock solution). The organic solvents added to the non-aqueous ink composition as a result of this operation are considered to be part of the liquid carrier.

In an embodiment, the non-aqueous ink composition of the present invention further comprises one or more amine compounds.

Amine compounds suitable for use in the non-aqueous ink compositions of the present invention include, but are not limited to, ethanolamines and alkylamines.

Examples of suitable ethanolamines include dimethylethanol amine [$(CH_3)_2NCH_2CH_2OH$], triethanolamine [$N(CH_2CH_2OH)_3$], and *N-tert*-butyldiethanolamine [$t\text{-}C_4H_9N(CH_2CH_2OH)_2$].

Alkylamines include primary, secondary, and tertiary alkylamines. Examples of primary alkylamines include, for example, ethylamine [$C_2H_5NH_2$], n-butylamine [$C_4H_9NH_2$], t-butylamine [$C_4H_9NH_2$], n-hexylamine [$C_6H_{13}NH_2$], 2-ethylhexylamine [$C_8H_{17}NH_2$], n-decylamine [$C_{10}H_{21}NH_2$], and ethylenediamine [$H_2NCH_2CH_2NH_2$]. Secondary alkylamines include, for example, diethylamine [$(C_2H_5)_2NH$], di(n-propylamine) [$(n\text{-}C_3H_9)_2NH$], di(isopropylamine)[$(i\text{-}C_3H_9)_2NH$], and dimethyl ethylenediamine [$CH_3NHCH_2CH_2NHCH_3$]. Tertiary alkylamines include, for example, trimethylamine [$(CH_3)_3N$], triethylamine [$(C_2H_5)_3N$], tri(n-butyl)amine [$(C_4H_9)_3N$], and tetramethyl ethylenediamine [$(CH_3)_2NCH_2CH_2N(CH_3)_2$].

In some embodiments, the amine compound is a tertiary alkylamine. In an embodiment, the amine compound is triethylamine.

In some embodiments, the amine compound is a mixture of a tertiary alkylamine compound and an amine compound other than a tertiary alkylamine compound. In an embodiment, the amine compound other than a tertiary alkylamine compound is a primary alkylamine compound. For the primary alkylamine compound, 2-ethylhexylamine or n-butylamine is preferable.

The amount of the amine compound can be adjusted and measured as a weight percentage relative to the total amount of the non-aqueous ink composition. In an embodiment, the amount of the amine compound is at least 0.01 wt. %, at least 0.10 wt. %, at least 1.00 wt. %, at least 1.50 wt. %, or at least 2.00 wt. %, with respect to the total amount of the non-aqueous ink composition. In an embodiment, the amount of the amine compound is from about 0.01 wt. % to about 2.00 wt. %, typically from about 0.05 wt. % to about 1.50 wt. %, more typically from about 0.1 wt. % to about 1.0 wt. %, with respect to the total amount of the non-aqueous ink composition. At least a portion of the amine compound may be present in the form of an ammonium salt, e.g., a trialkylammonium salt, of the sulfonated conjugated polymer

(an amine adduct of the sulfonated polythiophene).

This amine compound is added typically at the time of preparing the final non-aqueous ink composition, but may be added in advance at an earlier point in time. For example, as described above, the amine compound may be added to the sulfonated conjugated polymer, thereby converting it to the corresponding ammonium salt, e.g., a trialkylammonium salt (an amine adduct of the sulfonated polythiophene), followed by reduction treatment. Alternatively, the amine compound (e.g., triethylamine) may be added to a solution of a sulfonated conjugated polymer that has undergone reduction treatment, and the sulfonated conjugated polymer may be precipitated as an ammonium salt (e.g., a triethylammonium salt) in powder form, which can be recovered.

Although there is no particular limitation on methods of such treatment, exemplary methods include the following: the sulfonated polythiophene that has been subjected to reduction treatment is dissolved by adding to it water and triethylamine, the mixture is stirred under heating (for example, at 60 °C), and then isopropyl alcohol and acetone are added to the obtained solution to cause precipitation of the triethylammonium salt of the sulfonated conjugated polymer, which is filtered and recovered.

The non-aqueous ink composition of the present invention may optionally further comprise one or more matrix compounds known to be useful in hole injection layers (HILs) or hole transport layers (HTLs).

The optional matrix compound can be a lower or higher molecular weight compound, and is different from the polythiophene described herein. The matrix compound can be, for example, a synthetic polymer that is different from the polythiophene. See, for example, US Patent Publication No. 2006/0175582 published Aug. 10, 2006. The synthetic polymer can comprise, for example, a carbon backbone. In some embodiments, the synthetic polymer has at least one polymer side group comprising an oxygen atom or a nitrogen atom. The synthetic polymer may be a Lewis base. Typically, the synthetic polymer comprises a carbon backbone and has a glass transition temperature of greater than 25 °C. The synthetic polymer may also be a semi-crystalline or crystalline polymer that has a glass transition temperature equal to or lower than 25 °C and/or a melting point greater than 25 °C. The synthetic polymer may comprise one or more acidic groups, for example, sulfonic acid groups.

In an embodiment, the synthetic polymer is a polymeric acid comprising one or more repeating units comprising at least one alkyl or alkoxy group which is substituted by at least one fluorine atom and at least one sulfonic acid ($-SO_3H$) moiety, wherein said alkyl or alkoxy group is optionally interrupted by at least one ether linkage (-O-) group.

In an embodiment, the polymeric acid comprises a repeating unit complying with formula (II) and a repeating unit complying with formula (III)

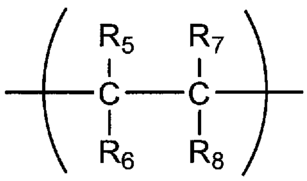

(II)

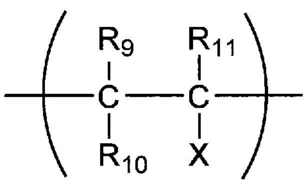

(III)

wherein each occurrence of $R_5$, $R_6$, $R_7$, $R_8$, $R_9$, $R_{10}$, and $R_{11}$ is, independently, H, halogen, fluoroalkyl, or perfluoroalkyl; and X is $-[OC(R_hR_i)-C(R_jR_k)]_q-O-[CR)R_m]_z-SO_3H$, wherein each occurrence of $R_h$, $R_i$, $R_j$, $R_k$, $R_l$ and $R_m$ is, independently, H, halogen, fluoroalkyl, or perfluoroalkyl; q is 0 to 10; and z is 1 to 5.

In an embodiment, each occurrence of $R_5$, $R_6$, $R_7$, and $R_8$ is, independently, Cl or F. In an embodiment, each occurrence of $R_5$, $R_7$, and $R_8$ is F, and $R_6$ is Cl. In an embodiment, each occurrence of $R_5$, $R_6$, $R_7$, and $R_8$ is F.

In an embodiment, each occurrence of $R_9$, $R_{10}$, and $R_{11}$ is F.

In an embodiment, each occurrence of $R_h$, $R_i$, $R_j$, $R_k$, $R_l$ and $R_m$ is, independently, F, ($C_1$-$C_8$) fluoroalkyl, or ($C_1$-$C_8$) perfluoroalkyl.

In an embodiment, each occurrence of $R_l$ and $R_m$ is F; q is 0; and z is 2.

In an embodiment, each occurrence of $R_5$, $R_7$, and $R_8$ is F, and $R_6$ is Cl; and each occurrence of $R_l$ and $R_m$ is F; q is 0; and z is 2.

In an embodiment, each occurrence of $R_5$, $R_6$, $R_7$, and $R_8$ is F; and each occurrence of $R_l$ and $R_m$ is F; q is 0;

and z is 2.

The ratio of the number of repeating units complying with formula (II) ("n") to the number of the repeating units complying with formula (III) ("m") is not particularly limited. The n:m ratio is typically from 9:1 to 1:9, more typically 8:2 to 2:8. In an embodiment, the n:m ratio is 9:1. In an embodiment, the n:m ratio is 8:2.

The polymeric acid suitable for use according to the present invention may be synthesized using methods known to those of ordinary skill in the art or obtained from commercially available sources. For instance, the polymers comprising a repeating unit complying with formula (II) and a repeating unit complying with formula (III) may be made by co-polymerizing monomers represented by formula (IIa) with monomers represented by formula (IIIa)

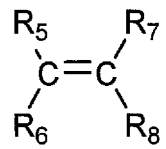
(IIa)

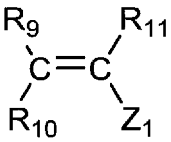
(IIIa)

wherein $Z_1$ is $-[OC(R_hR_i)-C(R_jR_k)]_q-O-[CR_lR_m]_z-SO_2F$, wherein $R_h$, $R_i$, $R_j$, $R_k$, $R_l$ and $R_m$, q, and z are as defined herein, according to known polymerization methods, followed by conversion to sulfonic acid groups by hydrolysis of the sulfonyl fluoride groups.

For example, tetrafluoroethylene (TFE) or chlorotrifluoroethylene (CTFE) may be copolymerized with one or more fluorinated monomers comprising a precursor group for sulfonic acid, such as, for example, $F_2C=CF-O-CF_2-CF_2-SO_2F$; $F_2C=CF-[O-CF_2-CR_{12}F-O]_q-CF_2-CF_2-SO_2F$, wherein $R_{12}$ is F or $CF_3$ and q is 1 to 10; $F_2C=CF-O-CF_2-CF_2-CF_2-SO_2F$; and $F_2C=CF-OCF_2-CF_2-CF_2-CF_2-SO_2F$.

The equivalent weight of the polymeric acid is defined as the mass, in grams, of the polymeric acid per mole of acidic groups present in the polymeric acid. The equivalent weight of the polymeric acid is from about 400 to about 15,000 g polymer/mol acid, typically from about 500 to about 10,000 g polymer/mol acid, more typically from about 500 to 8,000 g polymer/mol acid, even more typically from about 500 to 2,000 g polymer/mol acid, still more typically from about 600 to about 1,700 g polymer/mol acid.

Such polymeric acids are, for instance, those marketed by E. I. DuPont under the trade name NAFION®, those marketed by Solvay Specialty Polymers under the trade name AQUIVION®, or those marketed by Asahi Glass Co. under the trade name FLEMION®.

In an embodiment, the synthetic polymer is a polyether sulfone comprising one or more repeating units comprising at least one sulfonic acid ($-SO_3H$) moiety.

In an embodiment, the polyether sulfone comprises a repeating unit complying with formula (IV)

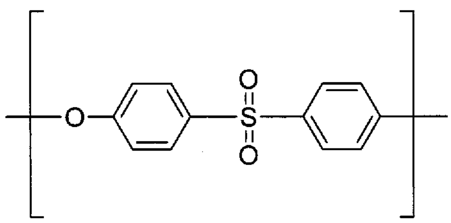
(IV)

and a repeating unit selected from the group consisting of a repeating unit complying with formula (V) and a repeating unit complying with formula (VI)

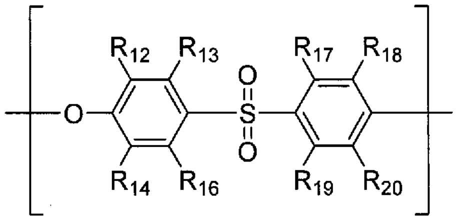

(V)

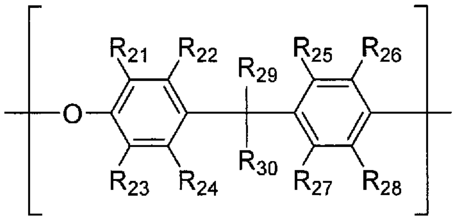

(VI)

wherein $R_{12}$-$R_{20}$ are each, independently, H, halogen, alkyl, or $SO_3H$, provided that at least one of $R_{12}$-$R_{20}$ is $SO_3H$; and wherein $R_{21}$-$R_{28}$ are each, independently, H, halogen, alkyl, or $SO_3H$, provided that at least one of $R_{21}$-$R_{28}$ is $SO_3H$, and $R_{29}$ and $R_{30}$ are each H or alkyl.

In an embodiment, $R_{29}$ and $R_{30}$ are each alkyl. In an embodiment, $R_{29}$ and $R_{30}$ are each methyl.

In an embodiment, $R_{12}$-$R_{17}$, $R_{19}$, and $R_{20}$, are each H and $R_{18}$ is $SO_3H$.

In an embodiment, $R_{21}$-$R_{25}$, $R_{27}$, and $R_{28}$, are each H and $R_{26}$ is $SO_3H$.

In an embodiment, the polyether sulfone is represented by formula (VII)

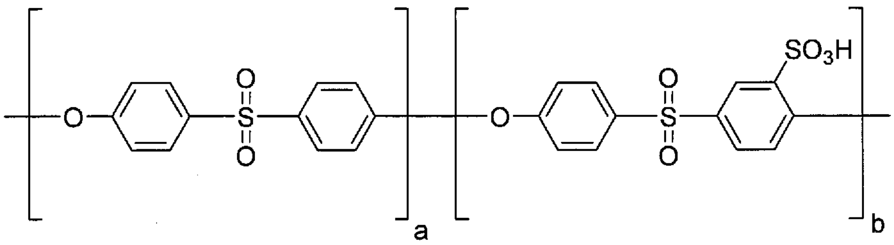

(VII)

wherein a is from 0.7 to 0.9 and b is from 0.1 to 0.3.

The polyether sulfone may further comprise other repeating units, which may or may not be sulfonated.

For example, the polyether sulfone may comprise a repeating unit of formula (VIII)

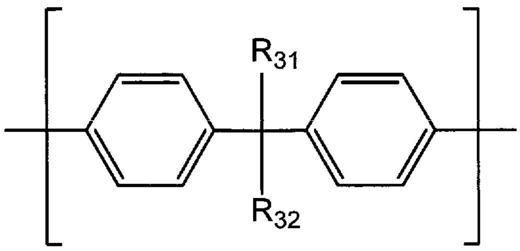

(VIII)

wherein $R_{31}$ and $R_{32}$ are each, independently, H or alkyl.

Any two or more repeating units described herein may together form a repeating unit and the polyether sulfone may comprise such a repeating unit. For example, the repeating unit complying with formula (IV) may be combined with a repeating unit complying with formula (VI) to give a repeating unit complying with formula (IX)

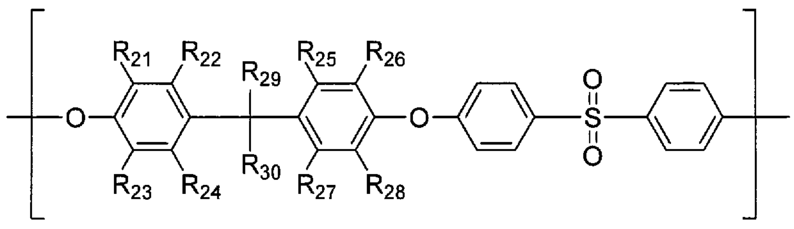

(IX).

Analogously, for example, the repeating unit complying with formula (IV) may be combined with a repeating unit complying with formula (VIII) to give a repeating unit complying with formula (X)

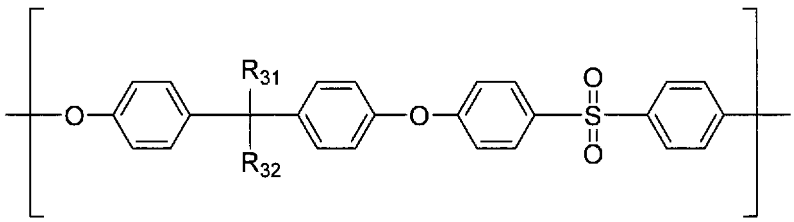

(X).

In an embodiment, the polyether sulfone is represented by formula (XI)

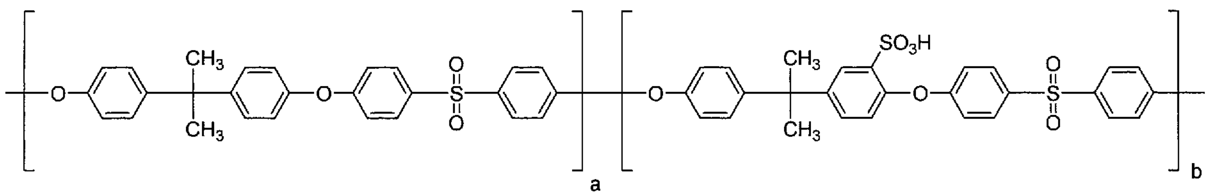

(XI)

wherein a is from 0.7 to 0.9 and b is from 0.1 to 0.3.

Polyether sulfones comprising one or more repeating units comprising at least one sulfonic acid ($-SO_3H$) moiety are commercially available, for example, sulfonated polyether sulfones marketed as S-PES by Konishi Chemical Ind. Co., Ltd.

The optional matrix compound can be a planarizing agent. A matrix compound or a planarizing agent may be comprised of, for example, a polymer or oligomer such as an organic polymer, such as poly(styrene) or poly(styrene) derivatives; poly(vinyl acetate) or derivatives thereof; poly(ethylene glycol) or derivatives thereof; poly(ethylene-co-vinyl acetate); poly(pyrrolidone) or derivatives thereof (e.g., poly(1-vinylpyrrolidone-co-vinyl acetate)); poly(vinyl pyridine) or derivatives thereof; poly(methyl methacrylate) or derivatives thereof; poly(butyl acrylate); poly(aryl ether ketones); poly(aryl sulfones); poly(esters) or derivatives thereof; or combinations thereof.

In an embodiment, the matrix compound is poly(styrene) or a poly(styrene) derivative.

In an embodiment, the matrix compound is poly(4-hydroxystyrene).

The optional matrix compound or planarizing agent may be comprised of, for example, at least one semiconducting matrix component. The semiconducting matrix component is different from the polythiophene described herein. The semiconducting matrix component can be a semiconducting small molecule or a semiconducting polymer that is typically comprised of repeat units comprising hole carrying units in the main-chain and/or in a side-chain. The semiconducting matrix component may be in the neutral form or may be doped, and is typically soluble and/or dispersible in organic solvents, such as toluene, chloroform, acetonitrile, cyclohexanone, anisole, chlorobenzene, o-dichlorobenzene, ethyl benzoate and mixtures thereof.

The amount of the optional matrix compound can be controlled and measured as a weight percentage relative to the amount of the doped or undoped polythiophene. In an embodiment, the amount of the optional matrix compound is from 0 to 99.5 wt. %, typically from about 10 wt. to about 98 wt. %, more typically from about 20 wt. % to about 95 wt. %, still more typically about 25 wt. % to about 45 wt. %, relative to the amount of the doped or undoped polythiophene. In the embodiment with 0 wt. %, the non-aqueous ink composition is free of matrix compound.

In an embodiment, the polythiophene comprising a repeating unit complying with formula (I) is doped with a dopant. Dopants are known in the art. See, for example, U.S. Patent 7,070,867; US Publication 2005/0123793; and US Publication 2004/0113127. The dopant can be an ionic compound. The dopant can comprise a cation and an anion. One or more dopants may be used to dope the polythiophene comprising a repeating unit complying with formula (I).

The cation of the ionic compound can be, for example, V, Cr, Mn, Fe, Co, Ni, Cu, Nb, Mo, Tc, Ru, Rh, Pd, Ag, Ta, W, Re, Os, Ir, Pt, or Au.

The cation of the ionic compound can be, for example, gold, molybdenum, rhenium, iron, and silver cation.

In some embodiments, the dopant can comprise a sulfonate or a carboxylate, including alkyl, aryl, and heteroaryl sulfonates and carboxylates. As used herein, "sulfonate" refers to a $-SO_3M$ group, wherein M may be $H^+$ or an alkali metal ion, such as, for example, $Na^+$, $Li^+$, $K^+$, $Rb^+$, $Cs^+$; or ammonium ($NH_4^+$). As used herein, "carboxylate" refers to a $-CO_2M$ group, wherein M may be $H^+$ or an alkali metal ion, such as, for example, $Na^+$, $Li^+$, $K^+$, $Rb^+$, $Cs^+$; or ammonium ($NH_4^+$). Examples of sulfonate and carboxylate dopants include, but are not limited to, benzoate compounds, heptafluorobutyrate, methanesulfonate, trifluoromethanesulfonate, p-toluenesulfonate, pentafluoropropionate, and polymeric sulfonates, perfluorosulfonate-containing ionomers, and the like.

In some embodiments, the dopant does not comprise a sulfonate or a carboxylate.

In some embodiments, dopants may comprise sulfonylimides, such as, for example, bis(trifluoromethanesulfonyl)imide; antimonates, such as, for example, hexafluoroantimonate; arsenates, such as, for example, hexafluoroarsenate; phosphorus compounds, such as, for example, hexafluorophosphate; and borates, such as, for example, tetrafluoroborate, tetraarylborates, and trifluoroborates. Examples of tetraarylborates include, but are not limited to, halogenatedtetraarylborates, such as tetrakispentafluorophenylborate (TPFB). Examples of trifluoroborates include, but are not limited to, (2-nitrophenyl)trifluoroborate, benzofurazan-5-trifluoroborate, pyrimidine-5-trifluoroborate, pyridine-3-trifluoroborate, and 2,5-dimethylthiophene-3-trifluoroborate.

A dopant can be, for example, a material that will undergo one or more electron transfer reaction(s) with, for example, a conjugated polymer, thereby yielding a doped polythiophene. The dopant can be selected to provide a suitable charge balancing counter-anion. A reaction can occur upon mixing of the polythiophene and the dopant as known in the art. For example, the dopant may undergo spontaneous electron transfer from the polymer to a cation-anion dopant, such as a metal salt, leaving behind a conjugated polymer in its oxidized form with an associated anion and free metal. See, for example, Lebedev et al., Chem. Mater., 1998, 10, 156-163. As disclosed herein, the polythiophene and the dopant can refer to components that will react to form a doped polymer. The doping reaction can be a charge transfer reaction, wherein charge carriers are generated, and the reaction can be reversible or irreversible. In some embodiments, silver ions may undergo electron transfer to or from silver metal and the doped polymer.

In the final formulation, the composition can be distinctly different from the combination of original components (i.e., polythiophene and/or dopant may or may not be present in the final composition in the same form as before mixing).

For the dopant, an inorganic acid, an organic acid, an organic or inorganic oxidizing agent, or the like is used.

For the organic acid, a polymeric organic acid and/or a low molecular organic acid (non-polymeric organic acid) are used.

In an embodiment, the organic acid is a sulfonic acid, and may also be a salt thereof ($-SO_3M$, wherein M is an alkali-metal ion (e.g., $Na^+$, $Li^+$, $K^+$, $Rb^+$, $Cs^+$, etc.), ammonium ($NH_4^+$), a mono-, di-, and tri- alkylammonium (e.g., triethylammonium)). Among the sulfonic acids, an arylsulfonic acid is preferred.

In some embodiments, examples of dopants include, but are not limited to, inorganic strong acids such as hydrogen chloride, sulfuric acid, nitric acid, and phosphoric acid; Lewis acids such as aluminum (III) chloride ($AlCl_3$), titanium (IV) tetrachloride (TiCl4), boron tribromide ($BBr_3$), boron trifluoride ether complex ($BF_3 \cdot OEt_2$), iron (III) chloride ($FeCl_3$), copper (II) chloride ($CuCl_2$), antimony (V) pentachloride ($SbCl_5$), arsenic (V) pentafluoride ($AsF_5$), phosphorus pentafluoride ($PF_5$), and tris(4-bromophenyl)aluminum hexachloroantimonate (TBPAH); polymeric organic acids such as polystyrene sulfonic acid; low molecular weight organic acids (non-polymeric organic acids) such as benzenesulfonic acid, tosylic acid, camphorsulfonic acid, hydroxybenzenesulfonic acid, 5-sulfosalicylic acid, dodecylbenzenesulfonic acid, 1,4-benzodioxanedisulfonic acid derivatives described in WO 2005/000832, arylsulfonic acid derivatives described in WO 2006/025342, dinonylnaphthalenesulfonic acid derivatives described in JP-A-2005-108828; organic or inorganic oxidizing agents such as 7,7,8,8-tetracyanoquinodimethane (TCNQ), 2,3-dichloro-5,6-dicyano-1,4-benzoquinone (DDQ), iodine, heteropoly acid compounds, and the like.

In some embodiments, the dopant comprises at least one selected from the group consisting of an arylsulfonic acid compound, a heteropoly acid compound, an ionic compound comprising an element belonging to Group 13 or 15 of the long periodic table.

Particularly preferred dopants include polymeric organic acids such as polystyrene sulfonic acid, and low molecular organic acids such as 5-sulfosalicylic acid, dodecylbenzenesulfonic acid, 1,4-benzodioxanedisulfonic acid derivatives described in WO 2005/000832, and dinonylnaphthalenesulfonic acid derivatives described in JP 2005-108828. A sulfonic acid derivative represented by the following formula (2) can also be suitably used.

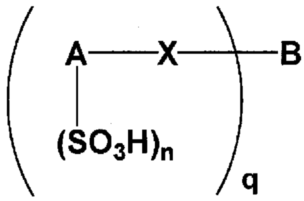

(2)

wherein X represents O, S or NH; A represents a naphthalene or anthracene ring which may have a substituent other than X or the n number of ($SO_3H$) groups; and B represents an unsubstituted or substituted hydrocarbon group, a 1,3,5-triazine group, or an unsubstituted or substituted group represented by formula (3) or (4) below:

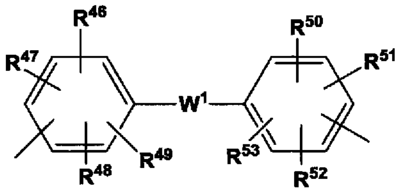

(3)

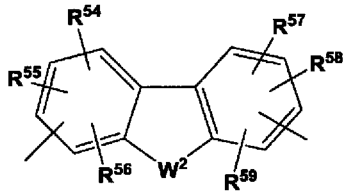

(4)

wherein $W^1$ and $W^2$ each, independently, represent O, S, an S(O) group, an $S(O_2)$ group, or an unsubstituted or substituted N, Si, P, or P(O) group; $W^1$ may also be a single bond; $R^{46}$ to $R^{59}$ each, independently, represent a hydrogen atom or a halogen atom;

n represents the number of sulfonic acid groups attached to A and is an integer satisfying $1 \leq n \leq 4$; and q represents the number of bonds between B and X, and is an integer satisfying $1 \leq q$.

$R^{46}$ to $R^{59}$ in formula (3) or (4) are preferably fluorine atoms, and more preferably all fluorine atoms. $W^1$ in formula (3) is preferably a single bond. Most preferably, $W^1$ in formula (3) is a single bond, and $R^{46}$ to $R^{53}$ are all fluorine atoms.

For the arylsulfonic acid compound according to the present invention, a compound represented by the following formula (6) may further be used:

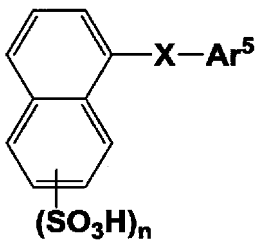

(6)

wherein X represents O, S or NH; $Ar^5$ represents an aryl group; and n represents the number of sulfonic groups and is an integer of 1 to 4.

In formula (6) above, X represents O, S or NH, and particularly preferably is O for ease of synthesis.

n represents the number of sulfonic groups attached to the naphthalene ring and is an integer of 1 to 4, and preferably, n=1 or 2, for the purpose of imparting high electron acceptability and high solubility to the compound. Among them, the compound represented by the following formula (7) is suitable:

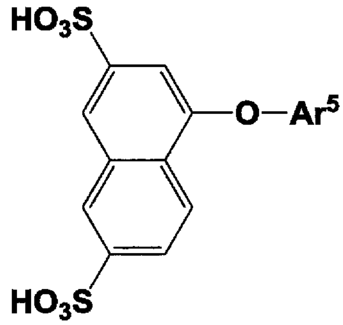

(7)

wherein $Ar^5$ represents an aryl group.

Examples of aryl groups in formulae (6) and (7) include aryl groups such as a phenyl group, a xylyl group, a tolyl group, a biphenyl group, and a naphthyl group, and these aryl groups may have a substituent.

Examples of such substituents include, but are not limited to, a hydroxyl group, an amino group, a silanol group, a thiol group, a carboxyl group, a phosphoric acid group, a phosphate ester group, an ester group, a thioester group, an amide group, a nitro group, a cyano group, a monovalent hydrocarbon group, an organooxy group, an organoamino group, an organosilyl group, an organothio group, an acyl group, a sulfonic group, a halogen atom, and the like.

Among these aryl groups, an aryl group represented by the following formula (8), in particular, is suitably used:

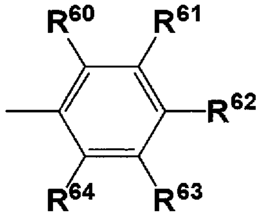

(8)

wherein $R^{60}$ to $R^{64}$ each, independently, represent a hydrogen atom, a halogen atom, a nitro group, an alkyl group having 1 to 10 carbon atoms, a halogenated alkyl group having 1 to 10 carbon atoms, and a halogenated alkenyl group having 2 to 10 carbon atoms.

In formula (8), the halogen atom may be any of chlorine, bromine, fluorine, and iodine atoms, but in the present invention, a fluorine atom is particularly suitable.

Examples of alkyl groups having 1 to 10 carbon atoms include methyl, ethyl, n-propyl, i-propyl, n-butyl, i-butyl, t-butyl, n-pentyl, n-hexyl, n-heptyl, n-octyl, n-nonyl, 2-ethylhexyl, n-decyl, cyclopentyl, cyclohexyl, and the like.

Examples of halogenated alkyl groups having 1 to 10 carbon atoms include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl, 1,1,2,2,3,3,4,4,4-nonafluorobutyl, and the like.

Examples of halogenated alkenyl groups having 2 to 10 carbon atoms include a perfluorovinyl group, a perfluoropropenyl group (allyl group), a perfluorobutenyl group, and the like.

Among these, for the purpose of further enhancing solubility in organic solvents, it is particularly preferable to use an aryl group represented by the following formula (9):

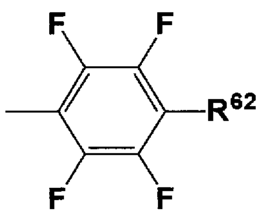

(9)

wherein, $R^{62}$ represents a hydrogen atom, a halogen atom, a nitro group, an alkyl group having 1 to 10 carbon atoms,

a halogenated alkyl group having 1 to 10 carbon atoms, or a halogenated alkenyl group having 2 to 10 carbon atoms.

In formula (9), $R^{62}$, in particular, is preferably a halogenated alkyl group, a halogenated alkynyl group, or a nitro group, and more preferably a trifluoromethyl group, a perfluoropropenyl group, or a nitro group.

Further, an ionic compound consisting of an anion represented by formula (5a) or $Z^1$ below and a countercation thereof can also be suitably used as a dopant.

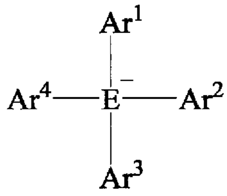

(5a)

wherein E represents an element belonging to Group 13 or 15 of the long periodic table; and $Ar^1$ to $Ar^4$ each, independently, represent an aromatic hydrocarbon group which may have a substituent or an aromatic heterocyclic group which may have a substituent.

In formula (5a), E is preferably boron, gallium, phosphorus, or antimony among the elements belonging to Group 13 or Group 15 of the long period periodic table, and more preferably boron.

Examples of aromatic hydrocarbon groups and aromatic heterocyclic groups in formula (5a) include a monovalent group derived from a 5- or 6-membered single-ring or bicyclo- to tetracyclo- fused-ring system. Among these, a monovalent group derived from a benzene ring, a naphthalene ring, a pyridine ring, a pyrazine ring, a pyridazine ring, a pyrimidine ring, a triazine ring, a quinoline ring, or an isoquinoline ring is preferable from the perspective of stability and heat resistance of the compound.

Further, it is more preferable that at least one group among $Ar^1$ to $Ar^4$ has one or more fluorine atoms or chlorine atoms as substituents. In particular, it is most preferable that $Ar^1$ to $Ar^4$ are perfluoroaryl groups in which all the hydrogen atoms are substituted with fluorine atoms. Specific examples of perfluoroaryl groups include a pentafluorophenyl group, a heptafluoro-2-naphthyl group, a tetrafluoro-4-pyridyl group, and the like.

Examples of $Z^1$ include an ion represented by the following formula (5b), and a hydroxide ion, fluoride ion, chloride ion, bromide ion, iodide ion, cyanide ion, nitrate ion, nitrite ion, sulfate ion, sulfite ion, perchlorate ion, perbromate ion, periodate ion, chlorate ion, chlorite ion, hypochlorite ion, phosphate ion, phosphite ion, hypophosphite ion, borate ion, isocyanate ion, hydrosulfide ion, tetrafluoroborate ion, hexafluorophosphate ion, and hexachloroantimonate ion; carboxylate ions such as an acetate ion, trifluoroacetate ion, and benzoate ion; sulfonate ions such as methanesulfonate and trifluoromethanesulfonate ions; and alkoxy ions, such as a methoxy ion, t-butoxy ion, and the like.

$$E^2X_6^- \qquad (5b)$$

wherein $E^2$ represents an element belonging to Group 15 of the long periodic table; and X represents a halogen atom such as a fluorine atom, a chlorine atom, or a bromine atom.

In formula (5b), $E^2$ is preferably a phosphorus atom, an arsenic atom, or an antimony atom, and is preferably a phosphorus atom from the perspectives of the stabilization, ease of synthesis and purification, and toxicity of the compound.

X is preferably a fluorine atom or a chlorine atom, most preferably a fluorine atom, from the perspectives of stability and ease of synthesis and purification of the compound.

Among the foregoing, an ionic compound which is the combination of an anion and a cation represented by the following formulae (10), (11), (12), or (13) (see Japanese Patent No. 5381931 (Patent Document 5)) can be suitably used.

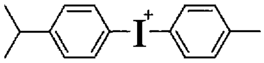 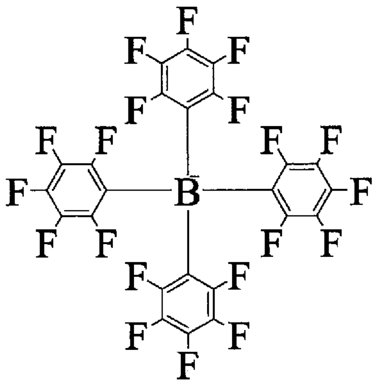 (10)

$Ag^+$ 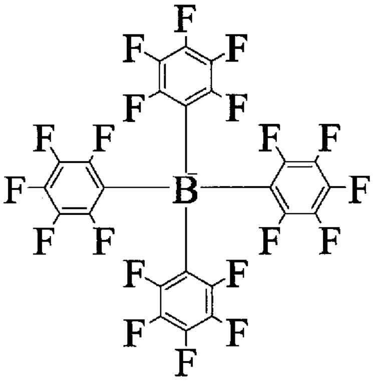 (11)

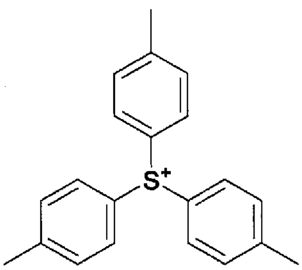 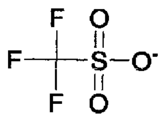 (12)

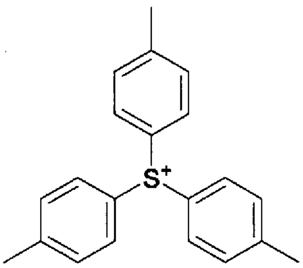 $^{-}PF_6$ (13)

Heteropoly acid compounds are also particularly preferable as dopants. A heteropoly acid compound is a polyacid having a structure in which a heteroatom is located at the center of the molecule, typically represented by a Keggin-type chemical structure shown in formula (A) or a Dawson-type chemical structure shown in formula (B), and is formed by condensation of an isopolyacid, which is an oxoacid of vanadium (V), molybdenum (Mo), tungsten (W), or the like with an oxoacid of a different element. Primary examples of such oxoacids of heterogeneous elements include oxoacids of silicon (Si), phosphorus (P), and arsenic (As).

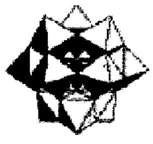 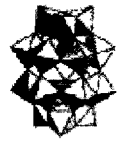

(A) (B)

Specific examples of heteropoly acid compounds include phosphomolybdic acid, silicomolybdic acid, phosphotungstic acid, phosphotungstomolybdic acid, silicotungstic acid, and the like. In consideration of the characteristics of an organic EL device comprising the resulting film, phosphomolybdic acid, phosphotungstic acid and silicotungstic acid are preferable, and phosphotungstic acid is more preferable.

These heteropoly acid compounds may be synthesized by a known synthesis method and used, but are also commercially available. For example, phosphotungstic acid (phosphotungstic acid hydrate or 12-tungstophosphoric acid n-hydrate, chemical formula: $H_3(PW_{12}O_{40})\cdot nH_2O$), and phosphomolybdic acid (phosphomolybdic acid hydrate or 12-molybdo (VI) phosphoric acid n-hydrate, chemical formula: $H_3(PMo_{12}O_{40})\cdot nH_2O$ ($n \approx 30$)) are available from manufacturers such as Kanto Chemical Co., Ltd., Wako Pure Chemical Industries, Ltd., Sigma-Aldrich Japan, Nippon Inorganic Colour & Chemical Co., Ltd., and Japan New Metals Co., Ltd.

In an embodiment, the sulfonic acid ester compound represented by formula (1) below, which is a precursor to a dopant, may be used as a dopant.

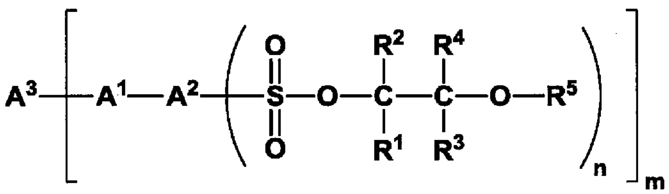 (1)

In formula (1), $R^1$ to $R^4$ are each, independently, a hydrogen atom or a linear or branched alkyl group of 1 to 6 carbon atoms; and $R^5$ is an optionally substituted monovalent hydrocarbon group of 2 to 20 carbon atoms.

Examples of linear or branched alkyl groups include, but are not limited to, a methyl group, an ethyl group, an n-propyl group, an isopropyl group, an n-butyl group, an isobutyl group, a tert-butyl group, and an n-hexyl group. Of these, an alkyl group of 1 to 3 carbon atoms is preferable.

Examples of monovalent hydrocarbon groups of 2 to 20 carbon atoms include alkyl groups such as an ethyl group, an n-propyl group, an isopropyl group, ab n-butyl group, an isobutyl group and a tert-butyl group, aryl groups such as a phenyl group, a naphthyl group and a phenanthryl group, and the like.

It is preferable for $R^1$ or $R^3$ to be a linear alkyl group of 1 to 3 carbon atoms and for the remainder of $R^1$ to $R^4$ to be hydrogen atoms. In addition, it is preferable for $R^1$ to be a linear alkyl group of 1 to 3 carbon atoms, and for $R^2$ to $R^4$ to be hydrogen atoms. The linear alkyl group of 1 to 3 carbon atoms is preferably a methyl group. $R^5$ is preferably a linear alkyl group of 2 to 4 carbon atoms or a phenyl group.

In formula (1), $A^1$ represents -O- or -S-, and is preferably -O-. $A^2$ is a group having a valence of n + 1 that is derived from naphthalene or anthracene, and is preferably a group derived from naphthalene. $A^3$ is an m-valent group derived from perfluorobiphenyl.

In formula (1), m is an integer that satisfies $2 \leq m \leq 4$, and is preferably 2. Also, n is an integer that satisfies $1 \leq n \leq 4$, and is preferably 2.

Some embodiments allow for removal of reaction by-products from the doping process. For example, the metals, such as silver, can be removed by filtration.

Materials can be purified to remove, for example, halogens and metals. Halogens include, for example, chloride, bromide and iodide. Metals include, for example, the cation of the dopant, including the reduced form of the cation of the dopant, or metals left from catalyst or initiator residues. Metals include, for example, silver, nickel, and magnesium. The amounts can be less than, for example, 100 ppm, or less than 10 ppm, or less than 1 ppm.

Metal content, including silver content, can be measured by ICP-MS, particularly for concentrations greater than 50 ppm.

In an embodiment, when the polythiophene is doped with a dopant, the polythiophene and the dopant are mixed to form a doped polymer composition. Mixing may be achieved using any method known to those of ordinary skill in the art. For example, a solution comprising the polythiophene may be mixed with a separate solution comprising the dopant. The solvent or solvents used to dissolve the polythiophene and the dopant may be one or more solvents described herein. A reaction can occur upon mixing of the polythiophene and the dopant as known in the art. The resulting doped

polythiophene composition comprises between about 40% and 75% by weight of the polymer and between about 25% and 55% by weight of the dopant, based on the composition. In another embodiment, the doped polythiophene composition comprises between about 50% and 65% by weight of the polythiophene and between about 35% and 50% by weight of the dopant, based on the composition. Typically, the amount by weight of the polythiophene is greater than the amount by weight of the dopant. Typically, the dopant can be a silver salt, such as silver tetrakis(pentafluorophenyl)borate in an amount of about 0.25 to 0.5 m/ru, wherein m is the molar amount of silver salt and ru is the molar amount of polymer repeat unit.

The total solids content (% TS) in the non-aqueous ink composition according to the present invention is from about 0.1 wt. % to about 50 wt. %, typically from about 0.3 wt. % to about 40 wt. %, more typically from about 0.5 wt. % to about 15 wt. %, still more typically from about 1 wt. % to about 5 wt. %, with respect to the total amount of non-aqueous ink composition.

The non-aqueous ink compositions described herein may be prepared according to any suitable method known to the ordinarily-skilled artisan. For example, in one method, an initial aqueous mixture is prepared by mixing an aqueous dispersion of the polythiophene described herein with an aqueous dispersion of polymeric acid, if desired, another matrix compound, if desired, and additional solvent, if desired. The solvents, including water, in the mixture are then removed, typically by evaporation. The resulting dry product is then dissolved or dispersed in one or more organic solvents, such as dimethyl sulfoxide, and filtered under pressure to yield a non-aqueous mixture. An amine compound may optionally be added to such non-aqueous mixture. The non-aqueous mixture is then mixed with a non-aqueous dispersion of the metal oxide nanoparticles to yield the final non-aqueous ink composition.

In another method, the non-aqueous ink compositions described herein may be prepared from stock solutions. For example, a stock solution of the polythiophene described herein can be prepared by isolating the polythiophene in dry form from an aqueous dispersion, typically by evaporation. The dried polythiophene is then combined with one or more organic solvents and, optionally, an amine compound. If desired, a stock solution of the polymeric acid described herein can be prepared by isolating the polymeric acid in dry form from an aqueous dispersion, typically by evaporation. The dried polymeric acid is then combined with one or more organic solvents. Stock solutions of other optional matrix materials can be made analogously. Stock solutions of the metal oxide nanoparticles can be made, for example, by diluting commercially-available dispersions with one or more organic solvents, which may be the same or different from the solvent or solvents contained in the commercial dispersion. Desired amounts of each stock solution are then combined to form the non-aqueous ink compositions of the present invention.

Still in another method, the non-aqueous ink compositions described herein may be prepared by isolating the individual components in dry form as described herein, but instead of preparing stock solutions, the components in dry form are combined and then dissolved in one or more organic solvents to provide the non-aqueous ink composition.

The non-aqueous ink composition according to the present invention can be cast and annealed as a film on a substrate.

Thus, the present invention also relates to a process for forming a hole-carrying film, the process comprising:

1) coating a substrate with a non-aqueous ink composition disclosed herein; and
2) annealing the coating on the substrate, thereby forming the hole-carrying film.

The coating of the non-aqueous ink composition on a substrate can be carried out by methods known in the art including, for example, spin casting, spin coating, dip casting, dip coating, slot-dye coating, inkjet printing, gravure coating, doctor blading, and any other methods known in the art for fabrication of, for example, organic electronic devices. It is preferable to coat a substrate with the non-aqueous ink composition by inkjet printing.

The substrate can be flexible or rigid, organic or inorganic. Suitable substrate compounds include, for example, glass, including, for example, display glass, ceramic, metal, and plastic films.

As used herein, the term "annealing" refers to any general process for forming a hardened layer, typically a film, on a substrate coated with the non-aqueous ink composition of the present invention. General annealing processes are known to those of ordinary skill in the art. Typically, the solvent is removed from the substrate coated with the non-aqueous ink composition. The removal of solvent may be achieved, for example, by subjecting the coated substrate to pressure less than atmospheric pressure, and/or by heating the coating layered on the substrate to a certain temperature (annealing temperature), maintaining the temperature for a certain period of time (annealing time), and then allowing the resulting layer, typically a film, to slowly cool to room temperature.

The step of annealing can be carried out by heating the substrate coated with the non-aqueous ink composition using any method known to those of ordinary skill in the art, for example, by heating in an oven or on a hot plate. Annealing can be carried out under an inert environment, for example, nitrogen atmosphere or noble gas atmosphere, such as, for example, argon gas. Annealing may be carried out in air atmosphere.

In an embodiment, the annealing temperature is from about 25 °C to about 350 °C, typically from about 150 °C to about 325 °C, more typically from about 200 °C to about 300 °C, still more typically from about 230 °C to about 300 °C.

The annealing time is the time for which the annealing temperature is maintained. The annealing time is from about 3 to about 40 minutes, typically from about 15 to about 30 minutes.

In an embodiment, the annealing temperature is from about 25 °C to about 350 °C, typically from about 150 °C to about 325 °C, more typically from about 200 °C to about 300 °C, still more typically from about 250 °C to about 300 °C, and the annealing time is from about 3 to about 40 minutes, typically for about 15 to about 30 minutes.

The present invention relates to the hole-carrying film formed by the process described herein.

Transmission of visible light is important, and good transmission (low absorption) at higher film thicknesses is particularly important. For example, the film made according to the process of the present invention can exhibit a transmittance (typically, with a substrate) of at least about 85%, typically at least about 90%, of light having a wavelength of about 380-800 nm. In an embodiment, the transmittance is at least about 90%.

In one embodiment, the film made according to the process of the present invention has a thickness of from about 5 nm to about 500 nm, typically from about 5 nm to about 150 nm, more typically from about 50 nm to 120 nm.

In an embodiment, the film made according to the process of the present invention exhibits a transmittance of at least about 90% and has a thickness of from about 5 nm to about 500 nm, typically from about 5 nm to about 150 nm, more typically from about 50 nm to 120 nm. In an embodiment, the film made according to the process of the present invention exhibits a transmittance (%T) of at least about 90% and has a thickness of from about 50 nm to 120 nm.

The films made according to the processes of the present invention may be made on a substrate optionally containing an electrode or additional layers used to improve electronic properties of a final device. The resulting films may be intractable to one or more organic solvents, which can be the solvent or solvents used as the liquid carrier in the ink for subsequently coated or deposited layers during fabrication of a device. The films may be intractable to, for example, toluene, which can be the solvent in the ink for subsequently coated or deposited layers during fabrication of a device.

The present invention also relates to a device comprising a film prepared according to the processes described herein. The devices described herein can be made by methods known in the art including, for example, solution processing. Inks can be applied and solvents removed by standard methods. The film prepared according to the processes described herein may be an HIL and/or HTL layer in the device.

Methods are known in the art and can be used to fabricate organic electronic devices including, for example, OLED and OPV devices. Methods known in the art can be used to measure brightness, efficiency, and lifetimes. Organic light emitting diodes (OLED) are described, for example, in U.S. Patents 4,356,429 and 4,539,507 (Kodak). Conducting polymers which emit light are described, for example, in U.S. Patents 5,247,190 and 5,401,827 (Cambridge Display Technologies). Device architecture, physical principles, solution processing, multilayering, blends, and compounds synthesis and formulation are described in Kraft et al., "Electroluminescent Conjugated Polymers Seeing Polymers in a New Light," Angew. Chem. Int. Ed., 1998, 37, 402-428, which is hereby incorporated by reference in its entirety.

Light emitters known in the art and commercially available can be used including various conducting polymers as well as organic molecules, such as compounds available from Sumation, Merck Yellow, Merck Blue, American Dye Sources (ADS), Kodak (e.g., A1Q3 and the like), and even Aldrich, such as BEHP-PPV. Examples of such organic electroluminescent compounds include:

(i) poly(p-phenylene vinylene) and its derivatives substituted at various positions on the phenylene moiety;

(ii) poly(p-phenylene vinylene) and its derivatives substituted at various positions on the vinylene moiety;

(iii) poly(p-phenylene vinylene) and its derivatives substituted at various positions on the phenylene moiety and also substituted at various positions on the vinylene moiety;

(iv) poly(arylene vinylene), where the arylene may be such moieties as naphthalene, anthracene, furylene, thienylene, oxadiazole, and the like;

(v) derivatives of poly(arylene vinylene), where the arylene may be as in (iv) above, and additionally have substituents at various positions on the arylene;

(vi) derivatives of poly(arylene vinylene), where the arylene may be as in (iv) above, and additionally have substituents at various positions on the vinylene;

(vii) derivatives of poly(arylene vinylene), where the arylene may be as in (iv) above, and additionally have substituents at various positions on the arylene and substituents at various positions on the vinylene;

(viii) co-polymers of arylene vinylene oligomers, such as those in (iv), (v), (vi), and (vii) with non-conjugated oligomers;

and

(ix) poly(p-phenylene) and its derivatives substituted at various positions on the phenylene moiety, including ladder polymer derivatives such as poly(9,9-dialkyl fluorene) and the like;

(x) poly(arylenes) where the arylene may be such moieties as naphthalene, anthracene, furylene, thienylene, oxadiazole, and the like; and their derivatives substituted at various positions on the arylene moiety;

(xi) co-polymers of oligoarylenes, such as those in (x) with non-conjugated oligomers;

(xii) polyquinoline and its derivatives;

(xiii) co-polymers of polyquinoline with p-phenylene substituted on the phenylene with, for example, alkyl or alkoxy groups to provide solubility; and

(xiv) rigid rod polymers, such as poly(p-phenylene-2,6-benzobisthiazole), poly(p-phenylene-2,6-benzobisoxazole), poly(p-phenylene-2,6-benzimidazole), and their derivatives;

(xv) polyfluorene polymers and co-polymers with polyfluorene units.

Preferred organic emissive polymers include SUMATION Light Emitting Polymers ("LEPs") that emit green, red, blue, or white light or their families, copolymers, derivatives, or mixtures thereof; the SUMATION LEPs are available from Sumation KK. Other polymers include polyspirofluorene-like polymers available from Covion Organic Semiconductors GmbH, Frankfurt, Germany (now owned by Merck®).

Alternatively, rather than polymers, small organic molecules that emit by fluorescence or by phosphorescence can serve as the organic electroluminescent layer. Examples of small-molecule organic electroluminescent compounds include: (i) tris(8-hydroxyquinolinato) aluminum (Alq); (ii) 1,3-bis(*N*,*N*-dimethylaminophenyl)-1,3,4-oxidazole (OXD-8); (iii) -oxo-bis(2-methyl-8-quinolinato)aluminum; (iv) bis(2-methyl-8-hydroxyquinolinato) aluminum; (v) bis(hydroxybenzoquinolinato) beryllium ($BeQ_2$); (vi) bis(diphenylvinyl)biphenylene (DPVBI); and (vii) arylamine-substituted distyrylarylene (DSA amine).

Such polymer and small-molecule compounds are well known in the art and are described in, for example, U.S. Patent 5,047,687.

The devices can be fabricated in many cases using multilayered structures which can be prepared by, for example, solution or vacuum processing, as well as printing and patterning processes. In particular, use of the embodiments described herein for hole injection layers (HILs), wherein the composition is formulated for use as a hole injection layer, can be carried out effectively.

Examples of HIL in devices include:

1) Hole injection in OLEDs including PLEDs and SMOLEDs; for example, for HIL in PLED, all classes of conjugated polymeric emitters where the conjugation involves carbon or silicon atoms can be used. For HIL in SMOLED, the following are examples: SMOLED containing fluorescent emitters; SMOLED containing phosphorescent emitters; SMOLEDs comprising one or more organic layers in addition to the HIL layer; and SMOLEDs where the small molecule layer is processed from solution or aerosol spray or any other processing methodology. In addition, other examples include HIL in dendrimer or oligomeric organic semiconductor based OLEDs; HIL in ambipolar light emitting FET's where the HIL is used to modify charge injection or as an electrode;

2) Hole extraction layer in OPV;

3) Channel material in transistors;

4) Channel material in circuits comprising a combination of transistors, such as logic gates;

5) Electrode material in transistors;

6) Gate layer in a capacitor;

7) Chemical sensor where modification of doping level is achieved due to association of the species to be sensed with the conductive polymer;

8) Electrode or electrolyte material in batteries.

A variety of photoactive layers can be used in OPV devices. Photovoltaic devices can be prepared with photoactive layers comprising fullerene derivatives mixed with, for example, conducting polymers as described in, for example, U.S. Patents 5,454,880; 6,812,399; and 6,933,436. Photoactive layers may comprise blends of conducting polymers, blends of conducting polymers and semiconducting nanoparticles, and bilayers of small molecules such as phthalocyanines, fullerenes, and porphyrins.

Common electrode compounds and substrates, as well as encapsulating compounds can be used.

In one embodiment, the cathode comprises Au, Ca, Al, Ag, or combinations thereof. In one embodiment, the anode comprises indium tin oxide. In one embodiment, the light emission layer comprises at least one organic compound.

Interfacial modification layers, such as, for example, interlayers, and optical spacer layers may be used.

Electron transport layers can be used.

The present invention also relates to a method of making a device described herein.

In an embodiment, the method of making a device comprises: providing a substrate; layering a transparent conductor, such as, for example, indium tin oxide, on the substrate; providing the non-aqueous ink composition described herein; layering the non-aqueous ink composition on the transparent conductor to form a hole injection layer or hole transport layer; layering an active layer on the hole injection layer or hole transport layer (HTL); and layering a cathode on the active layer.

As described herein, the substrate can be flexible or rigid, organic or inorganic. Suitable substrate compounds include, for example, glass, ceramic, metal, and plastic films.

In another embodiment, a method of making a device comprises applying the non-aqueous ink composition as described herein as part of an HIL or HTL layer in an OLED, a photovoltaic device, an ESD, a SMOLED, a PLED, a sensor, a supercapacitor, a cation transducer, a drug release device, an electrochromic device, a transistor, a field effect transistor, an electrode modifier, an electrode modifier for an organic field transistor, an actuator, or a transparent electrode.

The layering of the non-aqueous ink composition to form the HIL or HTL layer can be carried out by methods known in the art including, for example, spin casting, spin coating, dip casting, dip coating, slot-dye coating, inkjet printing, gravure coating, doctor blading, and any other methods known in the art for fabrication of, for example, organic electronic devices. The layering of the non-aqueous ink composition is preferably carried out by inkjet printing.

In one embodiment, the HIL layer is thermally annealed. In one embodiment, the HIL layer is thermally annealed at temperature of about 25 °C to about 350 °C, typically 150 °C to about 325 °C. In one embodiment, the HIL layer is thermally annealed at temperature of of about 25 °C to about 350 °C, typically 150 °C to about 325 °C, for about 3 to about 40 minutes, typically for about 15 to about 30 minutes.

In one embodiment, the HIL layer has a thickness of from about 5 nm to about 500 nm, typically from about 5 nm to about 150 nm, more typically from about 50 nm to 120 nm.

In an embodiment, the HIL layer exhibits a transmittance of at least about 90% and has a thickness of from about 5 nm to about 500 nm, typically from about 5 nm to about 150 nm, more typically from about 50 nm to 120 nm. In an embodiment, the HIL layer exhibits a transmittance (%T) of at least about 90% and has a thickness of from about 50 nm to 120 nm.

The non-aqueous ink compositions, pile-up suppressors and lifetime extension agents for an organic EL device according to the present invention are further illustrated by the following non-limiting examples.

**Examples**

The meanings of abbreviations used in the following examples are as follows.

MMA: Methyl methacrylate

HEMA: 2-Hydroxyethyl methacrylate

HPMA: 4-Hydroxyphenyl methacrylate

HPMA-QD: Compound synthesized by condensation reaction of 1 mol of 4-hydroxyphenyl methacrylate and 1.1 mol of 1,2-naphthoquinone-2-diazide-5-sulfonyl chloride

CHMI: *N*-cyclohexylmaleimide

PFHMA: 2-(Perfluorohexyl)ethyl methacrylate

MAA: Methacrylic acid

AIBN: α, α'-Azobisisobutyronitrile

QD1: Compound synthesized by condensation reaction of 1 mol of α, α, α'-tris(4-hydroxyphenyl)-1-ethyl-4-isopropylbenzene and 1.5 mol of 1,2-naphthoquinone-2-diazide-5-sulfonyl chloride

GT-401: Butanetetracarboxylic acid tetra(3,4-epoxycyclohexylmethyl) modified ε-caprolactone (trade name: Epolide GT-401 (manufactured by Daicel Corporation))

PGME: Propylene glycol monomethyl ether

PGMEA: Propylene glycol monomethyl ether acetate

CHN: cyclohexanone

The components used in the following examples are summarized in Table 1 below.

Table 1.

| | |
|---|---|
| S-poly(3-MEET) | Sulfonated poly(3-MEET) |
| TFE-VEFS 1 | TFE/perfluoro-2-(vinyloxy)ethane-1-sulfonic acid copolymer having equivalent weight of 676 g polymer/mol acid (available from Solvay as AQUIVION® D66-20BS); n:m = 8:2 |
| EG-ST | 20-21 wt. % silica dispersion in ethylene glycol (EG-ST, available from Nissan Chemical Industries); average particle diameter: 12 nm by BET method |
| EG silica sol (1) | 20.5 wt. % silica dispersion in ethylene glycol (a dispersion prepared by replacing the solvent in ST-O-40, available from Nissan Chemical Industries, which is a water-dispersed sol of silica having an average primary particle diameter of 21 nm, with ethylene glycol); particle diameter measured by BET method |
| EG silica sol (2) | 10.5 wt. % silica dispersion in ethylene glycol (a dispersion prepared by replacing the solvent in ST-OXS, available from Nissan Chemical Industries, which is a water-dispersed sol of silica having an average primary particle diameter of 5 nm, with ethylene glycol); particle diameter measured by sodium hydroxide titration in accordance with the following reference: George W. Sears Jr., Anal. Chem. 28 (12), pp. 1981-1983 (1956)) |
| Ammonia water | 28% Ammonia water |
| 2-EHA | 2-Ethylhexylamine |
| BA | Butylamine |
| EG | Ethylene glycol |
| DEG | Diethylene glycol |
| DEGBE | Diethylene glycol monobutyl ether |
| TEGBME | Triethylene glycol butyl methyl ether |
| 2-BOE | 2-(Benzyloxy)ethanol |
| TEGDME | Triethylene glycol dimethyl ether |

**(1) Preparation of charge transporting materials**

**Production Example 1**

Preparation of amine adduct of S-poly(3-MEET)

500 g of an aqueous dispersion of S-poly(3-MEET) (0.598% solids in water) was mixed with 0.858 g of triethylamine, and the resulting mixture was evaporated to dryness by rotary evaporation. The resulting residue was then further dried using a vacuum oven at 50 °C overnight to give an amine adduct of S-poly(3-MEET) as 3.8 g of a black powder product.

### Production Example 2

2.00 g of the amine adduct of S-poly(3-MEET) obtained in Production Example 1 was dissolved in 100 ml of 28% ammonia water (manufactured by Junsei Chemical Co., Ltd.) and the resulting solution was stirred at room temperature overnight. The resulting reaction mixture was subjected to reprecipitation with 1,500 mL of acetone, and the precipitate was collected by filtration. The obtained precipitate was dissolved again in 20 mL of water and 7.59 g of triethylamine (manufactured by Tokyo Chemical Industries Co., Ltd.) and stirred at 60 °C for 1 hour. After the resulting reaction mixture was cooled, it was subjected to reprecipitation with a mixed solvent of 1,000 mL of isopropyl alcohol and 500 mL of acetone, and the precipitate was collected by filtration. The obtained precipitate was dried in vacuo (0 mmHg) at 50 °C for 1 hour to obtain 1.30 g of S-poly(3-MEET)-A, which is a charge transporting material treated with ammonia water.

### (2) Preparation of charge transporting varnishes

### Example 1

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 1.13 g of ethylene glycol (manufactured by Kanto Chemical Co., Ltd.), 1.95 g of diethylene glycol (manufactured by Kanto Chemical Co., Ltd.), 4.88 g of triethylene glycol dimethyl ether (manufactured by Tokyo Chemical Industry Co., Ltd.), 0.98 g of 2-(benzyloxy)ethanol (manufactured by Kanto Chemical Co., Ltd.), and 0.032 g of butylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.75 g of EG-ST and 0.15 g of EG silica sol (2) were added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

### Example 2

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 1.13 g of ethylene glycol (manufactured by Kanto Chemical Co., Ltd.), 0.98 g of diethylene glycol (manufactured by Kanto Chemical Co., Ltd.), 2.93 g of triethylene glycol butyl methyl ether (manufactured by Tokyo Chemical Industry Co., Ltd.), 3.91 g of diethylene glycol monobutyl ether (manufactured by Kanto Chemical Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.75 g of EG-ST and 0.15 g of EG silica sol (2) were added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

### Example 3

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 1.20 g of ethylene glycol (manufactured by Kanto Chemical Co., Ltd.), 0.98 g of diethylene glycol (manufactured by Kanto Chemical Co., Ltd.), 2.93 g of triethylene glycol butyl methyl ether (manufactured by Tokyo Chemical Industry Co., Ltd.), 3.91 g of diethylene glycol monobutyl ether (manufactured by Kanto Chemical Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.82 g of EG-ST and 0.02 g of EG silica sol (2) were added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

**Example 4**

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 1.20 g of ethylene glycol (manufactured by Kanto Chemical Co., Ltd.), 0.98 g of diethylene glycol (manufactured by Kanto Chemical Co., Ltd.), 2.93 g of triethylene glycol butyl methyl ether (manufactured by Tokyo Chemical Industry Co., Ltd.), 3.91 g of diethylene glycol monobutyl ether (manufactured by Kanto Chemical Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.75 g of EG-ST and 0.08 g of EG silica sol (1) were added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

**Example 5**

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 0.41 g of ethylene glycol (manufactured by Kanto Chemical Co., Ltd.), 0.98 g of diethylene glycol (manufactured by Kanto Chemical Co., Ltd.), 2.93 g of triethylene glycol butyl methyl ether (manufactured by Tokyo Chemical Industry Co., Ltd.), 3.91 g of diethylene glycol monobutyl ether (manufactured by Kanto Chemical Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.01 g of EG-ST and 1.62 g of EG silica sol (2) were added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

**Comparative Example 1**

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 1.20 g of ethylene glycol (manufactured by Kanto Chemical Co., Ltd.), 1.95 g of diethylene glycol (manufactured by Kanto Chemical Co., Ltd.), 4.88 g of triethylene glycol dimethyl ether (manufactured by Tokyo Chemical Industry Co., Ltd.), 0.98 g of 2-(benzyloxy)ethanol (manufactured by Kanto Chemical Co., Ltd.), and 0.032 g of butylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.83 g of EG-ST was added,

the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

**Comparative Example 2**

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 1.20 g of ethylene glycol (manufactured by Kanto Chemical Co., Ltd.), 0.98 g of diethylene glycol (manufactured by Kanto Chemical Co., Ltd.), 2.93 g of triethylene glycol butyl methyl ether (manufactured by Tokyo Chemical Industry Co., Ltd.), 3.91 g of diethylene glycol monobutyl ether (manufactured by Kanto Chemical Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 0.83 g of EG-ST was added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

**Comparative Example 3**

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 10 wt. % solution of D66-20BS in ethylene glycol. This solution was prepared by stirring at 400 rpm at 90 °C for 1 hour using a hot stirrer.

Next, another vessel was provided, and 0.020 g of S-poly(3-MEET)-A, obtained in Production Example 2, was dissolved in 0.40 g of ethylene glycol (manufactured by Kanto Chemical Co., Ltd.), 0.98 g of diethylene glycol (manufactured by Kanto Chemical Co., Ltd.), 2.93 g of triethylene glycol butyl methyl ether (manufactured by Tokyo Chemical Industry Co., Ltd.), 3.91 g of diethylene glycol monobutyl ether (manufactured by Kanto Chemical Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.10 g of the 10 wt. % ethylene glycol solution of D66-20BS, and the resultant mixture was stirred for 1 hour at 400 rpm at 80 °C using a hot stirrer. Finally, 1.64 g of EG silica sol (2) was added, the resultant mixture was stirred using a hot stirrer at 400 rpm at 80 °C for 10 minutes, and the resulting dispersion was filtered through a PP syringe filter (pore size: 0.2 μm) to yield a 2 wt. % charge transporting varnish.

(3) **Preparation of positive photosensitive resin composition**

[Measuring Number Average Molecular Weight and Weight Average Molecular Weight]

The number average molecular weights and the weight average molecular weights of the copolymers obtained in accordance with the following synthetic examples were measured using a GPC system (LC-20AD) manufactured by Shimadzu Corporation, and Shodex columns KF-804L and 803L manufactured by Showa Denko Co., Ltd. and running the elution solvent tetrahydrofuran through the column at a flow rate of 1 ml/min (column temperature: 40 °C) for elution. The number average molecular weights (hereinafter referred to as Mn) and weight average molecular weights (hereinafter referred to as Mw) below represent polystyrene equivalent values.

<Synthesis Example 1>

10.0 g of MMA, 12.5 g of HEMA, 20.0 g of CHMI, 2.50 g of HPMA, 5.00 g of MAA, 3.20 g of AIBN were dissolved in 79.8 g of PGME and reacted at 60 °C to 100 °C for 20 hours to obtain an acrylic polymer solution (solids concentration: 40% by weight) (PI). The Mn and Mw of the obtained acrylic polymer PI were 3,700 and 6,100, respectively.

<Synthesis Example 2>

2.50 g of HPMA-QD, 7.84 g of PFHMA, 0.70 g of MAA, 1.46 g of CHMI, 0.33 g of AIBN were dissolved in 51.3 g of CHN and reacted at 110 °C for 20 hours while stirring to obtain an acrylic polymer solution (solids concentration:

20% by weight) (P2). The Mn and Mw of the obtained acrylic polymer P2 were 4,300 and 6,300, respectively.

A positive photosensitive resin composition was prepared by mixing 5.04 g of PI, obtained in Synthesis Example 1, and 0.05 g of P2, obtained in Synthesis Example 2, 0. 40 g of QD1, 0.09 g of GT-401, and 6.42 g of PGMEA, and stirring the mixture at room temperature for 3 hours to obtain a uniform solution.

**(4) Fabrication of a banked substrate**

After the positive photosensitive resin composition obtained in step (3) above was applied using a spin coater onto a ITO-glass substrate that had been ozone-cleaned for 10 minutes using a UV-312, manufactured by Technovision Inc., the substrate was subjected to pre-baking (heated at 100 °C for 120 seconds) on a hot plate to form a film having a thickness of 1.2 μm. This film was irradiated with ultraviolet light (light intensity at 365 nm: 5.5 mW/cm$^2$) for a certain period by an ultraviolet irradiator PLA-600FA, manufactured by Canon Inc., through a patterned mask having a large number of rectangular windows with a long side of 200 μm and a short side of 100 μm. Thereafter, the film was immersed in a 1.0% aqueous solution of TMAH for 120 seconds for development, and then the film was washed in flowing ultrapure water for 20 seconds. Next, the film on which rectangular patterns were formed was subjected to post-baking (heating at a temperature of 230 °C for 30 minutes) for curing, thereby obtaining a banked substrate.

**(5) Evaluation of film formability**

The charge transporting varnishes obtained in Examples 1 to 5 and Comparative Examples 1 to 3 were discharged into rectangular openings (film formation regions) on the banked substrate obtained in step (4) above using a Inkjet Designer, manufactured by Cluster Technology Co., Ltd., and the obtained coating films were dried under reduced pressure for 15 minutes at a reduced pressure (degree of vacuum) of 10 Pa or less, and then dried at 230 °C for 30 minutes on a hot plate to form a charge transporting film.

The cross-sectional shapes of the charge transporting films obtained for Examples 1 to 5 and Comparative Examples 1 to 3 were measured using a fine shape measuring instrument ET4000A (manufactured by Kosaka Laboratory Ltd.). The results obtained for the respective openings are shown in FIG. 1 (Example 1 and Comparative Example 1) and FIG. 2 (Examples 2 to 5 and Comparative Examples 2 to 3).

Further, Table 2 below shows the constitutions of the non-aqueous ink compositions used in Examples 1 to 5 and Comparative Examples 1 to 3 as well as the change in thickness for the obtained charge transporting films.

Table 2

| | Example 1 | Comparative Example 1 | Example 2 | Example 3 | Example 4 | Example 5 | Comparative Example 2 | Comparative Example 3 |
|---|---|---|---|---|---|---|---|---|
| S-poly(3-MEET)-A | 0.020 g | 0.020 g | 0.020 g | 0.020 g | 0.020 g | 0.020 g | 0.020 g | 0.020 g |
| | | | | | | | | |
| EG | 1.13 g (1.96 g) | 1.20 g (1.95 g) | 1.13 g (1.96 g) | 1.20 g (1.96 g) | 1.20 g (1.95 g) | 0.41g (1.97 g) | 1.20 g (1.95 g) | 0.40 g (1.97 g). |
| < The values in the ()'s represent values that include the EG in the form of the solvents/dispersion media in the TFE-VEFS solution and the silica sols > | | | | | | | | |
| DEG | 1.95 g | 1.95 g | 0.98 g | 0.98 g | 0.98 g | 0.98 g | 0.98 g | 0.98 g |
| TEGDME | 4.88 g | 4.88 g | | | | | | |
| TEGBME | | | 2.93 g | 2.93 g | 2.93 g | 2.93 g | 2.93 g | 2.93 g |
| DEGBE | | | 3.91 g | 3.91 g | 3.91 g | 3.91 g | 3.91 g | 3.91 g |
| 2-BOE | 0.98 g | 0.98 g | | | | | | |
| | | | | | | | | |
| BA | 0.032 g | 0.032 g | | | | | | |
| 2-EHA | | | 0.032 g | 0.032 g | 0.032 g | 0.032 g | 0.032 g | 0.032 g |
| | | | | | | | | |
| TFE-VEFS (D66-20BS) (weight of the solute) | 0.01 g | 0.01 g | 0.01 g | 0.01 g | 0.01 g | 0.01 g | 0.01 g | 0.01 g |
| | | | | | | | | |
| EG-ST (average primary particle diameter: 12 nm) | 0.75 g | 0.83 g | 0.75 g | 0.82 g | 0.75 g | 0.01 g | 0.83 g | |
| EG silica sol (1) (average primary particle diameter: 21 nm) | | | | | 0.08 g | | | |
| EG silica sol (1) (average primary particle diameter: 5 nm) | 0.15 g | | 0.15 g | 0.02 g | | 1.62 g | | 1.64 g |

Comparison of Example 1 with Comparative Example 1 (FIG. 1) and of Examples 2 to 5 with Comparative Examples 2 to 3 (FIG. 2) shows that the cross-sectional shapes of the charge transporting films obtained in the Examples exhibit clearly less climbing (increase in film thickness) in the vicinity of the banks than the cross sections of the films obtained in the Comparative Examples. That is, in the Examples, pile-up is suppressed as compared with the Comparative Examples. In particular, in Example 5, which corresponds to Comparative Example 3, except that 1.64 g of EG silica sol (2) was replaced with 0.01 g of EG-ST and 1.62 g of EG silica sol (2), a significant suppression of pile-up was observed relative to Comparative Example 3.

The results above have confirmed that using the non-aqueous ink composition of the present invention allows the suppression of the pile-up that occurs at the time of forming the charge transporting film. Thus, it is expected that, in the organic EL device obtained by using the non-aqueous ink composition of the present invention, the shortening of lifetime due to electrical defects and the uneven emission of light due to the uneven thickness of the light emitting layer are greatly ameliorated without excessively deteriorating other characteristics.

**(3) Fabrication and characterization of organic EL devices**

**Example 5-1**

The varnishes obtained in Example 1 and Comparative Example 1 were each applied to a banked ITO substrate by using a spin coater, and were subsequently dried at 120 °C under air atmosphere for 1 minute. Subsequently, the dried substrate was placed into a glove box and baked at 230 °C under air atmosphere for 15 minutes to form a film, 30 nm thick, on the substrate. For the banked ITO substrate, a banked ITO substrate was used that was prepared by forming a film of a polyimide resin having a thickness of 1.1 μm on the electrodes on a glass substrate (25 mm × 25 mm × 0.7 t) on the surface of which patterned thin film electrodes of indium tin oxide (ITO) having a thickness of 150 nm were formed and patterning the film (with many 2 mm × 2 mm squares) to form banks; the impurities on the surface of the glass substrate were removed by an $O_2$ plasma cleaning device (150 W, 30 seconds) prior to use.

Next, α-NPD (*N,N'*-di(1-naphthyl)-*N,N'*-diphenylbenzidine) was deposited using an vacuum evaporator (degree of vacuum: $1.0 \times 10^{-5}$ Pa) to a thickness of 30 nm at a rate of 0.2 nm/s on the banked ITO substrate on which the film was formed. Next, films of $Alq_3$, lithium fluoride and aluminum were successively laminated to obtain an organic electroluminescent device. In these steps, the deposition rates were set to 0.2 nm/s for $Alq_3$, 0.2 nm/s for aluminum, and 0.02 nm/s for lithium fluoride and the film thicknesses were set to 40 nm, 0.5 nm, and 80 nm, respectively.

In order to prevent characteristic deterioration under the influence of, among others, oxygen and water in the air, the organic EL device was sealed using sealing substrates before the characteristics thereof were evaluated. Sealing was performed by the following procedure. The organic EL device was placed between sealing substrates in a nitrogen atmosphere having an oxygen concentration of 2 ppm or less and a dew point of -76 °C or less, and the sealing substrates were bonded to each other using an adhesive (Moresco Moisture Cut WB90US (P), manufactured by MORESCO Corporation). In this step, a water-trapping agent (HD-071010W-40, manufactured by Dynic Corporation) was placed between the sealing substrates together with the organic EL device, and the sealing substrates stuck together were irradiated with UV light (wavelength: 365 nm, irradiation level: 6,000 mJ/cm$^2$), and then annealed at 80 °C for 1 hour to cure the adhesive.

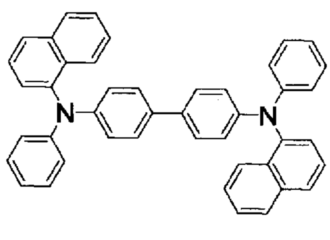

NPB

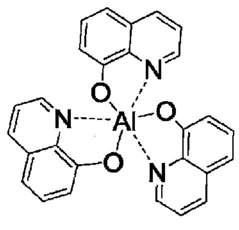

$Alq_3$

The drive voltage, current density, and luminous efficacy, as well as luminance half-life (time elapsed before luminance from an initial value of 5,000 cd/m$^2$ reaches half the initial value) when driving at a luminance of 5,000 cd/m$^2$ were measured. The results are shown in Table 3.

Table 3

| | Drive voltage (V) | Current density ($mA/cm^2$) | Current efficiency (cd/A) | External quantum efficiency (%) | Luminance half-life (hr) |
|---|---|---|---|---|---|
| Example 1 | 6.1 | 170.9 | 3.0 | 1.5 | 167 |
| Comparative Example 1 | 6.0 | 188.8 | 2.6 | 1.4 | <24 |

As is clear from the results above, the EL device prepared using the non-aqueous ink composition of the present invention exhibited no excessive deterioration in characteristics, and, in particular, the decrease in current efficiency was suppressed. Further, this EL device showed an extended luminance half-life, i.e. device lifetime, which is a reflection of the suppression of pile-up. That is, the non-aqueous ink composition of the present invention can suppress pile-up while avoiding excessive deterioration of organic EL device characteristics, thereby allowing the lifetime of the organic EL device to be extended.

## Claims

**1.** A non-aqueous ink composition comprising:

(a) a polythiophene comprising a repeating unit complying with formula (I):

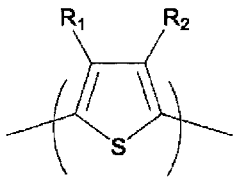

(I)

wherein $R_1$ and $R_2$ are each, independently, H, alkyl, fluoroalkyl, alkoxy, aryloxy, or $-O-[Z-O]_p-R_e$;
wherein

Z is an optionally halogenated hydrocarbylene group,
p is equal to or greater than 1, and
$R_e$ is H, alkyl, fluoroalkyl, or aryl;

(b) metal oxide nanoparticles comprising at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1<d_2$; and

(c) a liquid carrier comprising one or more organic solvents.

**2.** The composition according to claim 1, wherein the average primary particle diameter $d_1$ is less than 15 nm, and the average primary particle diameter $d_2$ is equal to or greater than 10 nm.

**3.** The composition according to claim 1 or 2, wherein the average primary particle diameter $d_1$ is equal to or greater than 3 nm and less than 15 nm; and the average primary particle diameter $d_2$ is equal to or greater than 10 nm and equal to or less than 30 nm.

**4.** The non-aqueous ink composition according to any one of claims 1 to 3, wherein the average primary particle diameters $d_1$ and $d_2$ satisfy the relation $d_2 / d_1 > 1.5$.

**5.** The non-aqueous ink composition according to any one of claims 1 to 4, wherein the average primary particle

diameters $d_1$ and $d_2$ satisfy the relation $d_2 / d_1 > 2.0$.

**6.** The non-aqueous ink composition according to any one of claims 1 to 5, wherein the amount of the metal oxide nanoparticles (b) is 1% by weight to 98% by weight relative to the combined weight of the metal oxide nanoparticles (b) and the polythiophene (a).

**7.** The non-aqueous ink composition according to any one of claims 1 to 6, wherein the weight ratio (b-1) / (b-2) of the first metal oxide nanoparticle (b-1) to the second metal oxide nanoparticle (b-2) in the metal oxide nanoparticles (b) is in the range of 0.001 to 1,000.

**8.** The non-aqueous ink composition according to any one of claims 1 to 7, wherein the first metal oxide nanoparticle (b-1) and the second metal oxide nanoparticle (b-2) each comprise, independently, $B_2O_3$, $B_2O$, $SiO_2$, $SiO$, $GeO_2$, $GeO$, $As_2O_4$, $As_2O_3$, $As_2O_5$, $Sb_2O_3$, $TeO_2$, $SnO_2$, $SnO$, or mixtures thereof.

**9.** The non-aqueous ink composition according to claim 8, wherein the first metal oxide nanoparticle (b-1) and the second metal oxide nanoparticle (b-2) both comprise $SiO_2$.

**10.** The non-aqueous ink composition according to any one of claims 1 to 9, wherein the liquid carrier is a liquid carrier comprising at least one glycol-based solvent (A) and at least one organic solvent (B) other than a glycol-based solvent.

**11.** The non-aqueous ink composition according to claim 10, wherein the glycol-based solvent (A) is a glycol ether, a glycol monoether, or a glycol.

**12.** The non-aqueous ink composition according to claim 10 or 11, wherein the organic solvent (B) is a nitrile, an alcohol, an aromatic ether, or an aromatic hydrocarbon.

**13.** The non-aqueous ink composition according to any one of claims 1 to 12, wherein $R_1$ and $R_2$ are each, independently, H, fluoroalkyl, $-O[C(R_aR_b)-C(R_cR_d)-O]_p-R_e$, $-OR_f$; wherein each occurrence of $R_a$, $R_b$, $R_c$, and $R_d$ is each, independently, H, halogen, alkyl, fluoroalkyl, or aryl; $R_e$ is H, alkyl, fluoroalkyl, or aryl; p is 1, 2, or 3; and $R_f$ is alkyl, fluoroalkyl, or aryl.

**14.** The non-aqueous ink composition according to claim 13, wherein $R_1$ is H and $R^2$ is other than H.

**15.** The non-aqueous ink composition according to claim 13, wherein $R_1$ and $R_2$ are both other than H.

**16.** The non-aqueous ink composition according to claim 15, wherein $R_1$ and $R_2$ are each, independently, $-O[C(R_aR_b)-C(R_cR_d)-O]_p-R_e$, or $-OR_f$.

**17.** The non-aqueous ink composition according to claim 15, wherein $R_1$ and $R^2$ are both $-O[C(R_aR_b)-C(R_cR_d)-O]_p-R_e$.

**18.** The non-aqueous ink composition according to claim 16 or 17, wherein each occurrence of $R_a$, $R_b$, $R_c$, and $R_d$ is each, independently, H, $(C_1-C_8)$ alkyl, $(C_1-C_8)$ fluoroalkyl, or phenyl; and $R_e$ is $(C_1-C_8)$ alkyl, $(C_1-C_8)$ fluoroalkyl, or phenyl.

**19.** The non-aqueous ink composition according to any one of claims 1 to 12, wherein the polythiophene comprises a repeating unit selected from the group consisting of

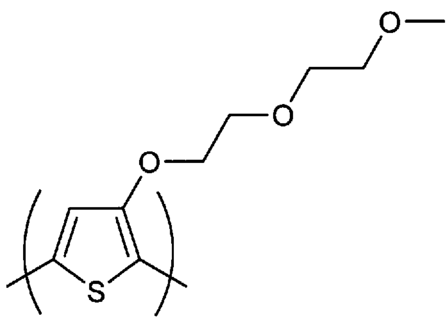

,

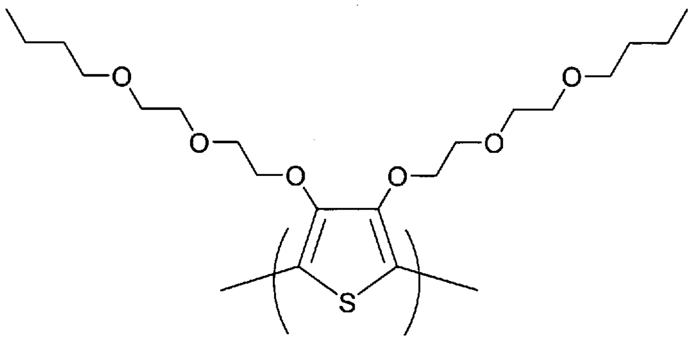

,

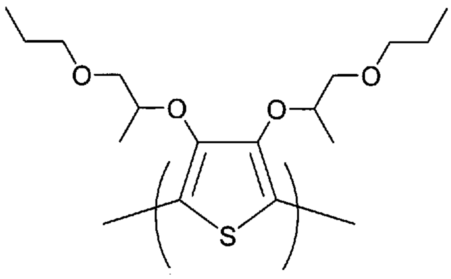

,

and combinations thereof.

**20.** The non-aqueous ink composition according to any one of claims 1 to 12, wherein the polythiophene is sulfonated.

**21.** The non-aqueous ink composition according to claim 20, wherein the polythiophene is sulfonated poly(3-MEET).

**22.** The non-aqueous ink composition according to any one of claims 1 to 21, wherein the polythiophene comprises repeating units complying with formula (I) in an amount of greater than 50% by weight, typically greater than 80% by weight, more typically greater than 90% by weight, even more typically greater than 95% by weight, based on the total weight of the repeating units.

**23.** The non-aqueous ink composition according to any one of claims 1 to 22, further comprising a synthetic polymer comprising one or more acidic groups.

**24.** The non-aqueous ink composition according to claim 23, wherein the synthetic polymer is a polymeric acid comprising one or more repeating units comprising at least one alkyl or alkoxy group substituted by at least one fluorine atom and at least one sulfonic acid ($-SO_3H$) moiety, wherein said alkyl or alkoxy group is optionally interrupted by at least one ether linking (-O-) group.

**25.** The non-aqueous ink composition according to claim 24, wherein the polymeric acid comprises a repeating unit complying with formula (II) and a repeating unit complying with formula (III):

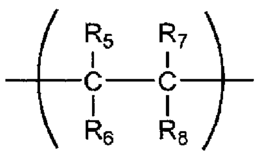
(II)

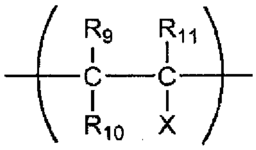

(III)

wherein

each occurrence of $R_5$, $R_6$, $R_7$, $R_8$, $R_9$, $R_{10}$, and $R_{11}$ is, independently, H, halogen, fluoroalkyl, or perfluoroalkyl; and

X is $-[OC(R_hR_i)-C(RjR_k)]_q-O-[CR_1R_m]_z-SO_3H$, wherein

each occurrence of $R_h$, $R_i$, $R_j$, $R_k$, $R_l$ and $R_m$ is, independently, H, halogen, fluoroalkyl, or perfluoroalkyl;

q is 0 to 10; and

z is 1 to 5.

**26.** The non-aqueous ink composition according to claim 23, wherein the synthetic polymer is a polyether sulfone comprising one or more repeating units comprising at least one sulfonic acid ($-SO_3H$) moiety.

**27.** The non-aqueous ink composition according to any one of claims 1 to 26, further comprising at least one amine compound.

**28.** The non-aqueous ink composition according to claim 27, wherein the amine compound comprises a tertiary alkylamine compound and an amine compound other than a tertiary alkylamine compound.

**29.** The non-aqueous ink composition according to claim 28, wherein the amine compound other than a tertiary alkylamine compound is a primary alkylamine compound.

**30.** The non-aqueous ink composition according to claim 29, wherein the primary alkylamine compound is at least one selected from the group consisting of ethylamine, n-butylamine, t-butylamine, n-hexylamine, 2-ethylhexylamine, n-decylamine, and ethylenediamine.

**31.** The non-aqueous ink composition according to claim 30, wherein the primary alkylamine compound is 2-ethylhexylamine or n-butylamine.

**32.** A pile-up suppressor for suppressing a pile-up phenomenon occurring during the formation of a charge transporting film by applying to a substrate having a liquid repellent bank, and drying, a non-aqueous ink composition if added to the non-aqueous ink composition, the pile-up suppressor comprising metal oxide nanoparticles,
wherein the metal oxide nanoparticles comprise at least (b-1) and (b-2) below:

(b-1) a first metal oxide nanoparticle having an average primary particle diameter $d_1$

(b-2) a second metal oxide nanoparticle having an average primary particle diameter $d_2$,

wherein the average primary particle diameters $d_1$ and $d_2$ satisfy the relation $d_1<d_2$.

**33.** The pile-up suppressor according to claim 32, wherein the average primary particle diameters $d_1$ and $d_2$ satisfy the relation $d_2 / d_1 > 1.5$.

**34.** The pile-up suppressor according to claim 32 or 33, wherein the average primary particle diameters $d_1$ and $d_2$ satisfy the relation $d_2/d_1 > 2.0$.

**35.** The pile-up suppressor according to any one of claims 32 to 34, wherein the first metal oxide nanoparticle (b-1) and the second metal oxide nanoparticle (b-2) each comprise, independently, $B_2O_3$, $B_2O$, $SiO_2$, $SiO$, $GeO_2$, $GeO$, $As_2O_4$, $As_2O_3$, $As_2O_5$, $Sb_2O_3$, $TeO_2$, $SnO_2$, $SnO$, or mixtures thereof.

**36.** The pile-up suppressor according to claim 35, wherein the first metal oxide nanoparticle (b-1) and the second metal oxide nanoparticle (b-2) both comprise $SiO_2$.

**37.** A non-aqueous ink composition comprising:

(a) a polythiophene comprising a repeating unit complying with formula (I):

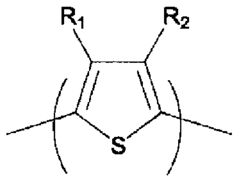

(I)

wherein $R_1$ and $R^2$ are each, independently, H, alkyl, fluoroalkyl, alkoxy, aryloxy, or -O-[Z-O]$_p$-$R_e$;
wherein

Z is an optionally halogenated hydrocarbylene group,
p is equal to or greater than 1, and
$R_e$ is H, alkyl, fluoroalkyl, or aryl;

(b) metal oxide nanoparticles comprising at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1<d_2$;

(c) a liquid carrier comprising one or more organic solvents;
(d) a synthetic polymer comprising one or more acidic groups; and
(e) at least one amine compound.

**38.** A lifetime extension agent for an organic EL device, comprising metal oxide nanoparticles, wherein the metal oxide nanoparticles comprise at least (b-1) and (b-2) below:

(b-1) a first metal oxide nanoparticle having an average primary particle diameter $d_1$
(b-2) a second metal oxide nanoparticle having an average primary particle diameter $d_2$,
wherein the average primary particle diameters $d_1$ and $d_2$ satisfy the relation $d_1<d_2$.

**39.** The lifetime extension agent according to claim 38, wherein the average primary particle diameters $d_1$ and $d_2$ satisfy the relation $d_2/d_1 > 1.5$.

**40.** The lifetime extension agent according to claim 38 or 39, wherein the average primary particle diameters $d_1$ and $d_2$ satisfy the relation $d_2/d_1 > 2.0$.

Fig. 1

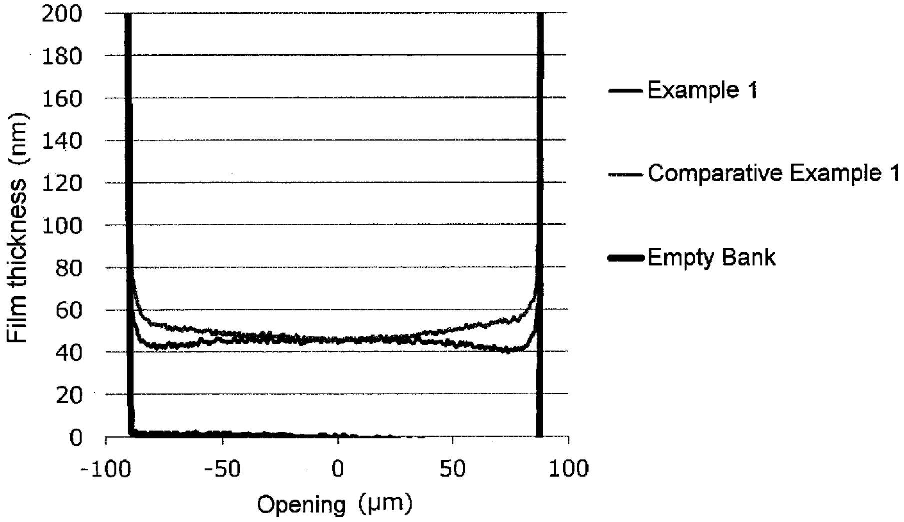
200
180
160
140
120
100
80
60
40
20
0
Film thickness (nm)
-100
-50
0
50
100
Opening (μm)
Example 1
Comparative Example 1
Empty Bank

Fig. 2

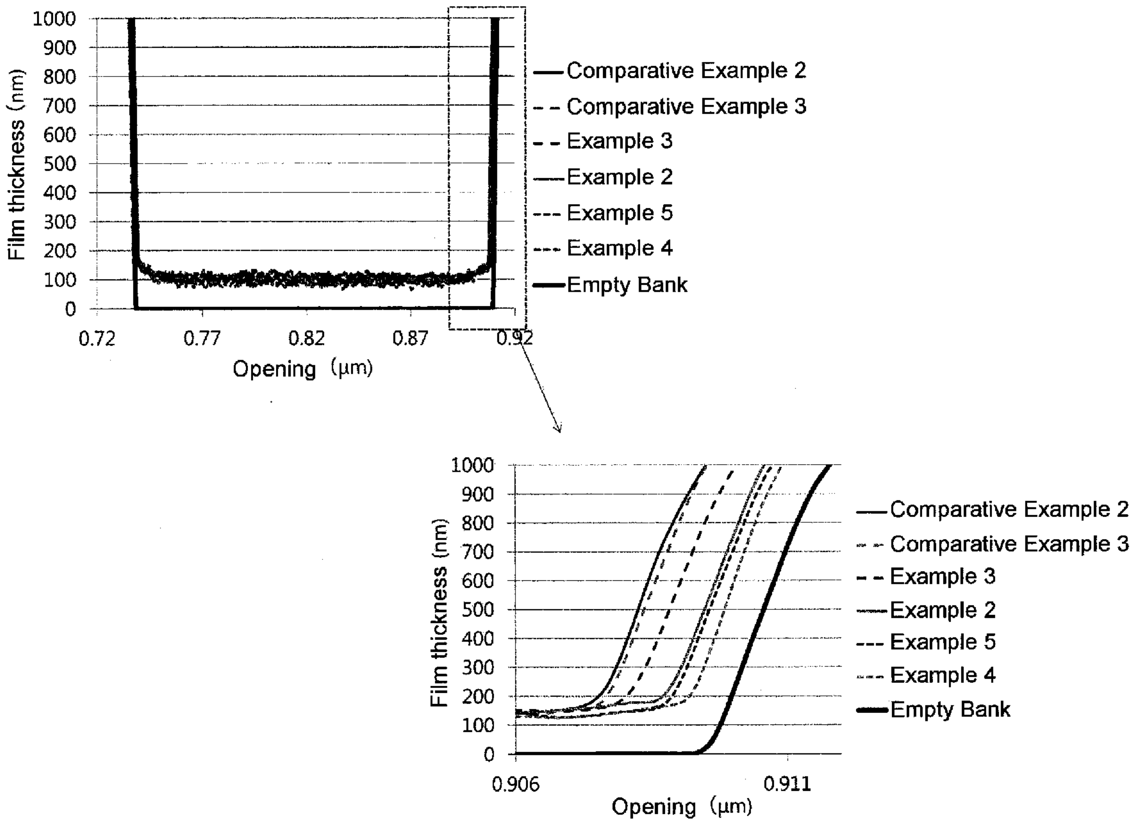
1000
900
800
700
600
500
400
300
200
100
0
Film thickness (nm)
0.72
0.77
0.82
0.87
0.92
Opening (μm)
Comparative Example 2
Comparative Example 3
Example 3
Example 2
Example 5
Example 4
Empty Bank
0.906
0.911

**INTERNATIONAL SEARCH REPORT**

International application No.
PCT/JP2018/023165

A. CLASSIFICATION OF SUBJECT MATTER
Int.Cl. C09D11/36(2014.01)i, C08K3/22(2006.01)i, C08K3/36(2006.01)i, C08L65/00(2006.01)i, C09D11/52(2014.01)i, H01B1/12(2006.01)i, H01L51/50(2006.01)i, H01B1/20(2006.01)n
According to International Patent Classification (IPC) or to both national classification and IPC

B. FIELDS SEARCHED
Minimum documentation searched (classification system followed by classification symbols)
Int.Cl. C09D11/36, C08K3/22, C08K3/36, C08L65/00, C09D11/52, H01B1/12, H01L51/50, H01B1/20

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2011-031501 A (FUJIFILM CORP.) 17 February 2011, claims, paragraphs [0002], [0009], [0019]-[0031], [0033]-[0037], [0042]-[0048], [0111], [0116], examples & US 2011/0026116 A1, claims, paragraphs [0003], [0011], [0035]-[0063], [0070]-[0074], [0081]-[0099], [0208]-[0211], [0225], examples | 1-15, 22-23, 25-27, 37 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 August 2018 (30.08.2018) | 11 September 2018 (11.09.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No. PCT/JP2018/023165

C (Continuation). DOCUMENTS CONSIDERED TO BE RELEVANT

| Category* | Citation of document, with indication, where appropriate, of the relevant passages | Relevant to claim No. |
|---|---|---|
| X | JP 2010-055899 A (SHARP CORP.) 11 March 2010, claims, paragraphs [0027], [0031], [0051]-[0060], [0069], [0087]-[0091], [0110]-[0115], examples (Family: none) | 1, 4-7, 13-15, 22-23, 25-26, 32-36, 38-40 |
| X | WO 2016/171935 A1 (SOLVAY USA INC.) 27 October 2016, claims, page 1, lines 12-15, page 9, line 5 to page 17, line 30, page 18, lines 25-30, page 19, line 25 to page 23, line 27, examples & US 2018/0105709 A1 & EP 3286271 A1 & CN 107532022 A & KR 10-2017-0139592 A | 1, 4-27, 32-40 |
| A | WO 2009/141903 A1 (PIONEER CORP.) 26 November 2009, entire text & US 2011/0062481 A1, entire text & EP 2287939 A1 | 1-40 |
| A | JP 2012-048099 A (LINTEC CORP.) 08 March 2012, entire text (Family: none) | 1-40 |
| A | JP 2014-103290 A (KONICA MINOLTA, INC.) 05 June 2014, entire text (Family: none) | 1-40 |
| A | JP 2016-181355 A (SHIN-ETSU CHEMICAL CO., LTD.) 13 October 2016, entire text & US 2016/0286641 A1, entire text & EP 3073494 A1 & KR 10-2016-0113978 A | 1-40 |
| A | JP 2006-502254 A (E. I. DU PONT DE NEMOURS AND COMPANY) 19 January 2006, entire text & US 2004/0124504 A1, entire text & WO 2004/029176 A1 & EP 1546283 A1 & KR 10-2005-0084574 A & CN 1685031 A | 1-40 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2016171935 A
- WO 2017014945 A
- WO 2017014946 A
- WO 2016140205 A
- JP 2015185640 A
- US 6602974 B, McCullough
- US 6166172 A, McCullough
- US 8865025 B
- US 8017241 B, Seshadri
- US 20100292399 A
- US 2010010900 A
- US 20100108954 A
- US 7070867 B
- US 20050123793 A
- US 20040113127 A
- US 20060175582 A
- WO 2005000832 A
- WO 2006025342 A
- JP 2005108828 A
- JP 5381931 B
- US 4356429 A
- US 4539507 A
- US 5247190 A
- US 5401827 A
- US 5047687 A
- US 5454880 A
- US 6812399 B
- US 6933436 B


### Non-patent literature cited in the description


- **LEBEDEV et al.** *Chem. Mater.,* 1998, vol. 10, 156-163
- **GEORGE W. SEARS JR.** *Anal. Chem.,* 1956, vol. 28 (12), 1981-1983
- **KRAFT et al.** Electroluminescent Conjugated Polymers Seeing Polymers in a New Light. *Angew. Chem. Int. Ed.,* 1998, vol. 37, 402-428